# EUROPEAN PATENT APPLICATION

(11) **EP 4 661 614 A1**
(43) Date of publication of application: **10.12.2025**
(21) Application number: 25160372.6
(22) Date of filing: 26.02.2025
(51) Int. Cl.: H10B 12/00

(54) **SEMICONDUCTOR DEVICES**

(30) Priority: 03.06.2024 KR 20240072599
(71) Applicant: Samsung Electronics Co., Ltd., Suwon-si, Gyeonggi-do 16677 (KR)
(72) Inventor: CHOI, Jae Hyun, 16677 Suwon-si (KR); LEE, Sangho, 16677 Suwon-si (KR); LEE, Hyun-Jung, 16677 Suwon-si (KR); JEONG, Moonyoung, 16677 Suwon-si (KR)
(74) Representative: Marks & Clerk LLP

(57) **Abstract**

A semiconductor device, comprising: a gate electrode and a back-gate electrode on a substrate, wherein the gate electrode and the back-gate electrode are spaced apart from each other in a first direction and extend in a second direction; a semiconductor pattern between the gate electrode and the back-gate electrode in the first direction, wherein the semiconductor pattern extends in a third direction; an upper gate capping pattern on the gate electrode; and an upper back-gate capping pattern on the back-gate electrode, wherein the semiconductor pattern extends between the upper gate capping pattern and the upper back-gate capping pattern, and wherein the upper gate capping pattern comprises a first insulating material having a first dielectric constant that is greater than a second dielectric constant of a second insulating material in the upper back-gate capping pattern.

## Description

### BACKGROUND OF THE INVENTION

The present disclosure relates to a semiconductor device and a method of fabricating the same, and in particular, to a semiconductor memory device including vertical channel transistors and a method of fabricating the same.

A semiconductor device may include an integrated circuit consisting of metal-oxide-semiconductor field-effect transistors (MOS-FETs). To meet an increasing demand for a semiconductor device with a small pattern size and a reduced design rule, the MOS-FETs are being scaled down. The scale-down of the MOS-FETs may lead to deterioration in operational properties of the semiconductor device. A variety of studies are conducted to overcome technical limitations associated with the scale-down of the semiconductor device and provide high performance semiconductor device.

### SUMMARY OF THE INVENTION

An embodiment of the inventive concept may provide a semiconductor device including vertical channel transistors with improved operation characteristics and a method of fabricating the same.

According to an embodiment of the inventive concept, a semiconductor device, comprising: a gate electrode and a back-gate electrode on a substrate, wherein the gate electrode and the back-gate electrode are spaced apart from each other in a first direction that is parallel to an upper surface of the substrate and extend in a second direction that is parallel to the upper surface of the substrate and intersects the first direction; a semiconductor pattern between the gate electrode and the back-gate electrode in the first direction, wherein the semiconductor pattern extends in a third direction that is perpendicular to the upper surface of the substrate; an upper gate capping pattern on the gate electrode; and an upper back-gate capping pattern on the back-gate electrode, wherein the semiconductor pattern extends between the upper gate capping pattern and the upper back-gate capping pattern, and wherein the upper gate capping pattern comprises a first insulating material having a first dielectric constant that is greater than a second dielectric constant of a second insulating material in the upper back-gate capping pattern.

According to an embodiment of the inventive concept, a semiconductor device, comprising: a gate electrode and a back-gate electrode on a substrate, wherein the gate electrode and the back-gate electrode are spaced apart from each other in a first direction that is parallel to an upper surface of the substrate; a semiconductor pattern between the gate electrode and the back-gate electrode in the first direction, wherein the semiconductor pattern extends in a vertical direction perpendicular to the upper surface of the substrate; an upper gate capping pattern on the gate electrode; an upper back-gate capping pattern on the back-gate electrode; an upper insulating layer on the upper gate capping pattern and the upper back-gate capping pattern; and an upper conductive contact extending in the upper insulating layer and electrically connected to the semiconductor pattern, wherein the semiconductor pattern comprises: a channel region between the gate electrode and the back-gate electrode; and an upper source/drain region between the upper gate capping pattern and the upper back-gate capping pattern, the upper source/drain region is electrically connected to the upper conductive contact, and the upper gate capping pattern comprises a first insulating material having a first dielectric constant that is greater than a second dielectric constant of a second dielectric material in the upper back-gate capping pattern.

At least some of the above and other features of the invention are set out in the claims.

### BRIEF DESCRIPTION OF THE DRAWINGS

FIG. 1 is a block diagram illustrating a semiconductor device according to an embodiment of the inventive concept.
FIGS. 2 and 3 are perspective views schematically illustrating semiconductor devices according to some embodiments of the inventive concept.
FIG. 4 is a plan view illustrating a semiconductor device according to an embodiment of the inventive concept.
FIG. 5 is a sectional view taken along a line A-A' of FIG. 4.
FIG. 6 is an enlarged sectional view of a portion 'PP' of FIG. 5.
FIG. 7 is an enlarged sectional view illustrating a portion (e.g., 'PP' of FIG. 5) of a semiconductor device according to an embodiment of the inventive concept.
FIG. 8 is an enlarged sectional view illustrating a portion (e.g., 'PP' of FIG. 5) of a semiconductor device according to an embodiment of the inventive concept.
FIGS. 9 to 14 are sectional views illustrating a method of fabricating a semiconductor device according to an embodiment of the inventive concept and corresponding to the line A-A' of FIG. 4.
FIGS. 15 to 18 are sectional views illustrating a method of fabricating a semiconductor device according to an embodiment of the inventive concept and corresponding to the line A-A' of FIG. 4.

### DETAILED DESCRIPTION

Example embodiments of the inventive concepts will now be described more fully with reference to the accompanying drawings, in which example embodiments are shown.

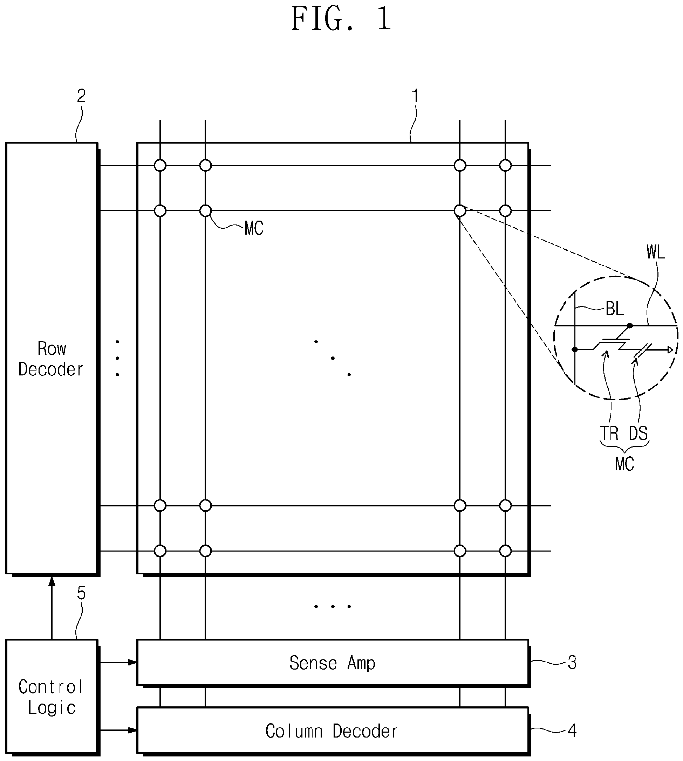

FIG. 1 is a block diagram illustrating a semiconductor device according to an embodiment of the inventive concept.

Referring to FIG. 1, a semiconductor device may include a memory cell array 1, a row decoder 2, a sense amplifier 3, a column decoder 4, and a control logic 5.

The memory cell array 1 may include a plurality of memory cells MC, which are two-dimensionally or three-dimensionally arranged. Each of the memory cells MC may be disposed between and (electrically) connected to a word line WL and a bit line BL crossing each other. Each of the memory cells MC may include a selection element TR and a data storing element DS. The selection element TR and the data storing element DS may be (electrically) connected to each other. The selection element TR may be (electrically) connected to the word line WL and the bit line BL and may be provided at an intersection point between the word line WL and the bit line BL. "Electrical connection" conceptually includes a physical connection and a physical disconnection (e.g. physical separation).

The selection element TR may include a field effect transistor. The data storing element DS may include, for example, a capacitor, a magnetic tunnel junction pattern, or a variable resistor. In the case where the selection element TR includes the field effect transistor, a gate terminal of the transistor may be (electrically) connected to the word line WL, and source/drain terminals of the transistor may be (electrically) connected to the bit line BL and the data storing element DS, respectively.

The row decoder 2 may be configured to decode address information, which may be input from the outside, and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit (e.g., the control logic 5). As used hereinafter, the terms "external/outside configuration", "external/outside device", "external/outside power", "external/outside signal", or "outside" are intended to broadly refer to a device, circuit, block, module, power, and/or signal that resides externally (e.g., outside of a functional or physical boundary) with respect to a given circuit, block, module, system, or device.

The sense amplifier 3 may be configured to sense, amplify, and output a voltage difference between one of the bit lines BL, which is selected based on address information decoded by the column decoder 4, and a reference bit line.

The column decoder 4 may provide a data transmission path between the sense amplifier 3 and an external device (e.g., a memory controller). The column decoder 4 may be configured to decode address information, which is input from the outside, and to select one of the bit lines BL of the memory cell array 1, based on the decoded address information. The control logic 5 may generate control signals, which are used to control an operation of writing or reading data to or from the memory cell array 1.

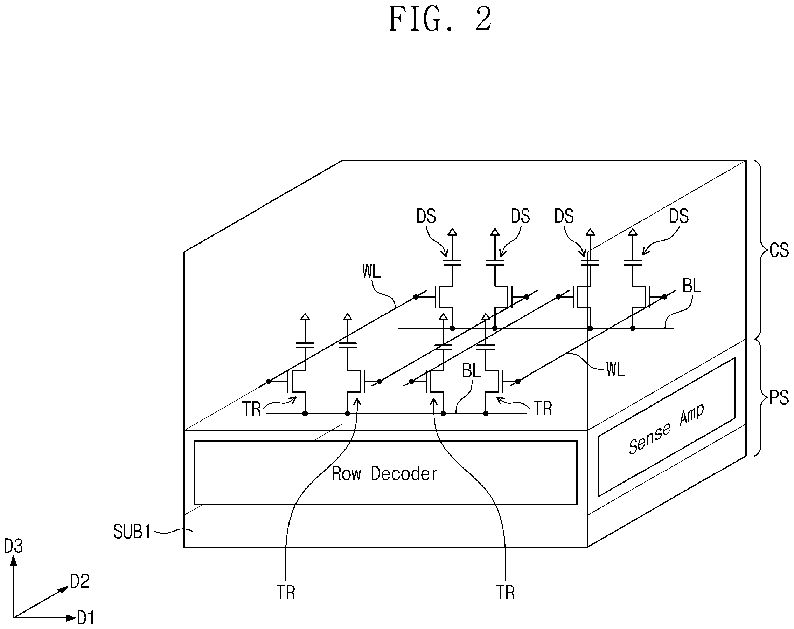

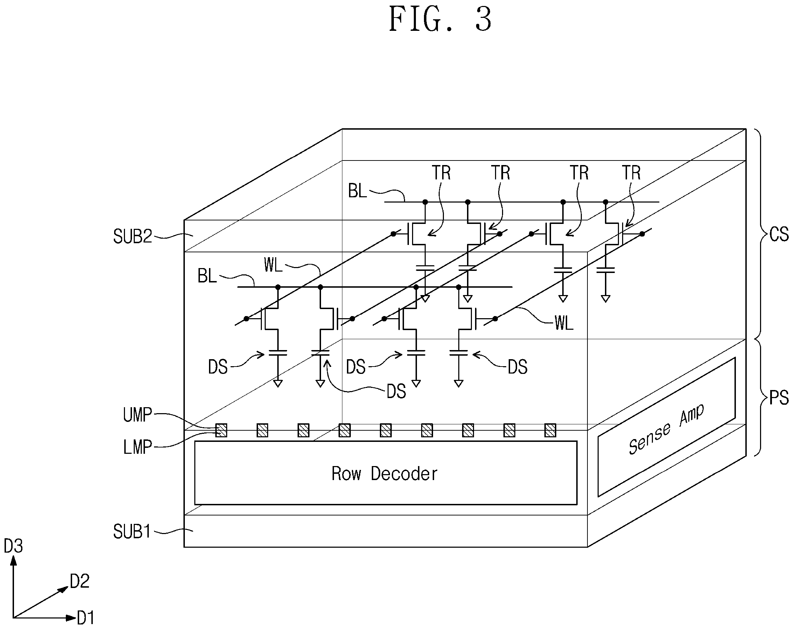

FIGS. 2 and 3 are perspective views schematically illustrating semiconductor devices according to some embodiments of the inventive concept.

Referring to FIGS. 2 and 3, the semiconductor device may include a peripheral circuit structure PS on a first substrate SUB1 and a cell array structure CS on the peripheral circuit structure PS. Hereinafter, a first direction D1 and a second direction D2 may be parallel to an upper surface (e.g., a top surface) of the first substrate SUB1 and may intersect to each other (e.g. may be perpendicular to each other), and a third direction D3 may be perpendicular to the upper surface of the first substrate SUB1. The peripheral circuit structure PS and the cell array structure CS may be stacked on the first substrate SUB1 in the third direction D3. The third direction D3 may define a vertical direction. The terms "upper" and "lower" may refer to relative positions along the third direction. That is, an upper feature D3 may be further along the third direction D3 than a lower feature. It will be appreciated that these positions and directions are defined relative to the structure of the semiconductor device, and need not imply any particular orientation of the semiconductor device in use.

The peripheral circuit structure PS may include core and peripheral circuits, which are formed on the first substrate SUB1. The core and peripheral circuits may include the row and column decoders 2 and 4, the sense amplifier 3, and the control logics 5 described with reference to FIG. 1.

The cell array structure CS may include the memory cell array 1 of FIG. 1, which includes the memory cells MC of FIG. 1 that are two-dimensionally or three-dimensionally arranged. In an embodiment, the selection element TR of each of the memory cells MC (e.g., see FIG. 1) may include a vertical channel transistor (VCT). The vertical channel transistor may include a channel pattern, which is elongated in the third direction D3.

Referring to FIG. 2, the peripheral circuit structure PS in an embodiment may be disposed between the first substrate SUB1 and the cell array structure CS and may be electrically connected to the cell array structure CS through conductive contacts.

Referring to FIG. 3, the semiconductor device in an embodiment may have a chip-to-chip (C2C) bonding structure. In detail, the peripheral circuit structure PS may be provided on the first substrate SUB1, and first metal pads LMP may be disposed in an upper portion of the peripheral circuit structure PS. The first metal pads LMP may be electrically connected to the core and peripheral circuits. The cell array structure CS may be provided on a second substrate SUB2. Second metal pads UMP may be provided in a lower portion of the cell array structure CS. The second metal pads UMP may be electrically connected to the memory cell array (e.g., the memory cell array 1 of FIG. 1). The first metal pads LMP in the peripheral circuit structure PS may be directly bonded to the second metal pads UMP of the cell array structure CS. The peripheral circuit structure PS and the cell array structure CS may be electrically connected to each other through the first and second metal pads LMP and UMP.

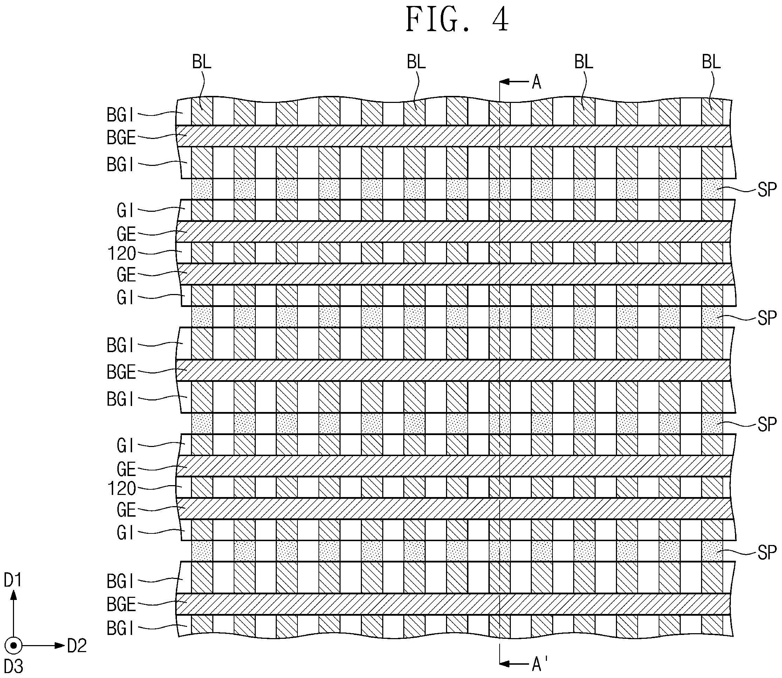

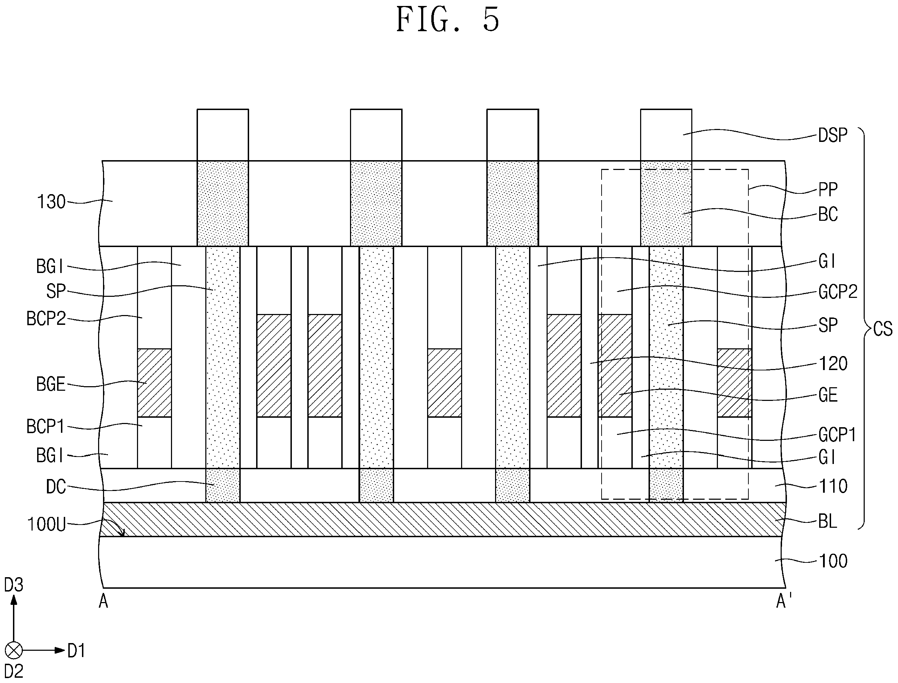

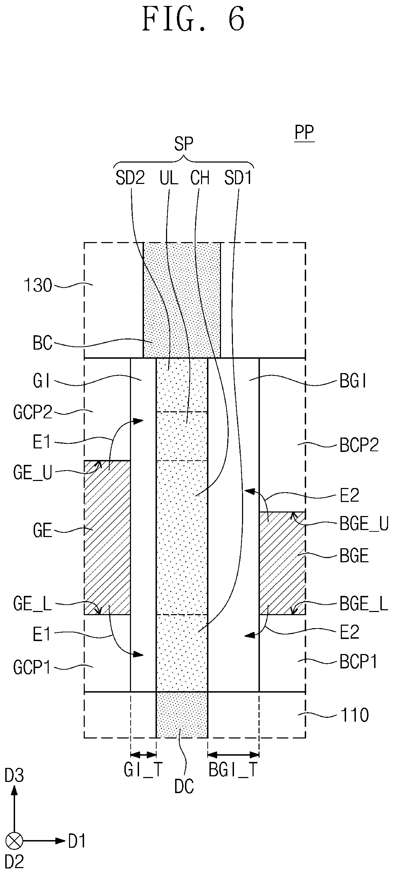

FIG. 4 is a plan view illustrating a semiconductor device according to an embodiment of the inventive concept. FIG. 5 is a sectional view taken along a line A-A' of FIG. 4, and FIG. 6 is an enlarged sectional view of a portion 'PP' of FIG. 5.

Referring to FIGS. 4 and 5, the cell array structure CS described with reference to FIGS. 2 and 3 may be disposed on a substrate 100. In an embodiment, the substrate 100 may include the first substrate SUB1 and the peripheral circuit structure PS of FIG. 2 and may further include an insulating layer on (covering or overlapping in the third direction D3) the peripheral circuit structure PS. The cell array structure CS may be disposed on the insulating layer. In an embodiment, the substrate 100 may include the second substrate SUB2 of FIG. 3 and may further include an insulating layer on the second substrate SUB2. The cell array structure CS may be disposed on the insulating layer.

Elements of the cell array structure CS will be described below.

Bit lines BL may be disposed on the substrate 100. The bit lines BL may be extended in a first direction D1 and may be spaced apart from each other in a second direction D2. The first and second directions D1 and D2 may be parallel to an upper surface (e.g., a top surface) 100U of the substrate 100 and may intersect (e.g., be orthogonal) to each other. Insulating patterns may be interposed between the bit lines BL and may be extended in the first direction D1 between the bit lines BL. The bit lines BL may include a conductive material. As an example, the bit lines BL may be formed of or include one or more doped semiconductor materials (e.g., doped silicon and/or doped germanium), one or more metallic materials (e.g., Ti, Mo, W, Cu, Al, Ta, Ru, Ir, and/or Co), one or more metal silicide materials (e.g., silicide materials containing Ti, Mo, W, Cu, Al, Ta, Ru, Ir, and/or Co) and/or one or more conductive metal nitride materials (e.g., one or more nitride materials containing Ti, Mo, W, Cu, Al, Ta, Ru, Ir, and/or Co). The insulating patterns may be formed of or include an insulating material (e.g., silicon oxide, silicon nitride, and/or silicon oxynitride).

Lower conductive contacts DC may be disposed on the bit lines BL and may be spaced apart from each other in the first and second directions D1 and D2. Ones of the lower conductive contacts DC, which are spaced apart from each other in the first direction D1, may be disposed on a corresponding one of the bit lines BL and may be spaced apart from each other in the first direction D1 on the corresponding bit line BL. The lower conductive contacts DC, which are spaced apart from each other in the first direction D1, may be (electrically) connected in common to the corresponding bit line BL. Ones of the lower conductive contacts DC, which are spaced apart from each other in the second direction D2, may be disposed on and (electrically) connected to the bit lines BL, respectively. The lower conductive contacts DC may include a conductive material, such as one or more doped semiconductor materials (e.g., doped silicon and/or doped germanium).

A lower insulating layer 110 may be disposed on the bit lines BL and may be interposed between the lower conductive contacts DC. Each of the lower conductive contacts DC may be provided to extend in (e.g., penetrate) the lower insulating layer 110 and may be (electrically) connected to a corresponding one of the bit lines BL. The lower insulating layer 110 may be formed of or include, for example, silicon oxide, silicon nitride, and/or silicon oxynitride.

In an embodiment, the lower conductive contacts DC, which are spaced apart from each other in the first direction D1, may be extended in the first direction D1 and may be (electrically) connected to each other to constitute a single lower conductive line. In this case, the lower conductive lines may be disposed on the bit lines BL, respectively, and may be extended in the first direction D1. The lower conductive lines may be spaced apart from each other in the second direction D2 and may be (electrically) connected to the bit lines BL, respectively. In an embodiment, the lower insulating layer 110 may be interposed between the lower conductive lines and may be extended in the first direction D1 between the lower conductive lines.

Semiconductor patterns SP may be disposed on the lower conductive contacts DC, respectively. The semiconductor patterns SP may be spaced apart from each other in the first and second directions D1 and D2. Some of the semiconductor patterns SP, which are spaced apart from each other in the first direction D1, may be (electrically) connected to the corresponding bit line BL through the lower conductive contacts DC, which are spaced apart from each other in the first direction D1. Some of the semiconductor patterns SP, which are spaced apart from each other in the second direction D2, may be electrically connected to the bit lines BL, respectively, through the lower conductive contacts DC, which are spaced apart from each other in the second direction D2. Each of the semiconductor patterns SP may be a vertical semiconductor pattern that is elongated in a third direction D3 perpendicular to the upper surface 100U of the substrate 100.

The semiconductor patterns SP may include a semiconductor material. In an embodiment, the semiconductor patterns SP may include, for example, silicon (e.g., single crystalline silicon), germanium, and/or silicon-germanium. In an embodiment, the semiconductor patterns SP may include, for example, an oxide semiconductor material (e.g., InGaZnO, InGaSiO, InSnZnO, InZnO, ZnO, ZnSnO, ZnON, ZrZnSnO, SnO, HfInZnO, GaZnSnO, AlZnSnO, YbGaZnO, and/or InGaO). In an embodiment, the semiconductor patterns SP may include, for example, a two-dimensional semiconductor material (e.g., graphene, carbon nanotube, and/or combinations thereof).

Gate electrodes GE may be disposed on the lower insulating layer 110 to cross over (e.g., overlap in the third direction D3) the bit lines BL. The gate electrodes GE may be extended in the second direction D2 and may be spaced apart from each other in the first direction D1. Back-gate electrodes BGE may be disposed on the lower insulating layer 110 to cross over (e.g., overlap in the third direction D3) the bit lines BL. The back-gate electrodes BGE may be extended in the second direction D2 and may be spaced apart from each other in the first direction D1. The gate electrodes GE and the back-gate electrodes BGE may be spaced apart from each other in the first direction D1.

The semiconductor patterns SP, which are spaced apart from each other (e.g. adjacent) in the second direction D2 (e.g. each row of semiconductor patterns SP in the second direction D2), may be disposed between a corresponding one of the gate electrodes GE and a corresponding one of the back-gate electrodes BGE (in the first direction D1). That is, the semiconductor patterns SP may form rows in the second direction D2, and each row may be located between a corresponding one of the gate electrodes GE and a corresponding one of the back-gate electrodes BGE (in the first direction D1). Semiconductor patterns SP, which are spaced apart from each other (e.g. adjacent) in the second direction D2 may be otherwise known as a row of semiconductor patterns SP (in the second direction D2).

A gate insulating pattern GI may be interposed between the semiconductor patterns SP, which are spaced apart from each other in the second direction D2, and the corresponding gate electrode GE (in the first direction D1) and may be extended in the second direction D2. That is, for each row of semiconductor patterns SP, a gate insulating pattern GI may be interposed between the row of semiconductor patterns SP and the corresponding gate electrode GE. A back-gate insulating pattern BGI may be interposed between the semiconductor patterns SP, which are spaced apart from each other in the second direction D2, and the corresponding back-gate electrode BGE (in the first direction D1) and may be extended in the second direction D2. That is, for each row of semiconductor patterns SP, a back gate insulating pattern BGI may be interposed between the row of semiconductor patterns SP and the corresponding back gate electrode BGE.

A pair of the gate electrodes GE, which are (most) adjacent to each other in the first direction D1, may be disposed between a pair of the semiconductor patterns SP, which are (most) adjacent to each other in the first direction D1. The pair of the gate electrodes GE and the pair of the semiconductor patterns SP may be disposed between a pair of the back-gate electrodes BGE, which are (most) adjacent to each other in the first direction D1. The gate insulating pattern GI may be interposed between each of the pair of gate electrodes GE and each of the pair of semiconductor patterns SP. For example, the pair of the gate electrodes GE may include a first gate electrode GE and a second gate electrode GE, and the pair of the semiconductor patterns SP may include a first semiconductor pattern SP and a second semiconductor pattern SP. The first gate electrode GE and the first semiconductor pattern SP may be adjacent to each other with a (first) gate insulating pattern GI therebetween in the first direction D1. The second gate electrode GE and the second semiconductor pattern SP may be adjacent to each other with a (second) gate insulating pattern GI therebetween in the first direction D1. The back-gate insulating pattern BGI may be interposed between each of the pair of back-gate electrodes BGE and each of the pair of semiconductor patterns SP. For example, the pair of the back-gate electrodes BGE may include a first back-gate electrode BGE and a second back-gate electrode BGE. The first back-gate electrode BGE and the first semiconductor pattern SP may be adjacent to each other with a (first) back-gate insulating pattern BGI therebetween in the first direction D1. The second back-gate electrode BGE and the second semiconductor pattern SP may be adjacent to each other with a (second) back-gate insulating pattern BGI therebetween in the first direction D1.

An isolation insulating pattern 120 may be interposed between the pair of the gate electrodes GE and may be extended in the second direction D2. The pair of the gate electrodes GE may be electrically separated (e.g., insulated) from each other by the isolation insulating pattern 120.

The gate electrodes GE and the back-gate electrodes BGE may include, for example, a conductive material, such as one or more metallic materials (e.g., Ti, Mo, W, Cu, Al, Ta, Ru, Ir, and/or Co), one or more metal silicide materials (e.g., one or more silicide materials containing Ti, Mo, W, Cu, Al, Ta, Ru, Ir, and/or Co), and/or one or more conductive metal nitride materials (e.g., one or more nitride materials containing Ti, Mo, W, Cu, Al, Ta, Ru, Ir, and/or Co). The gate insulating pattern GI and the back-gate insulating pattern BGI may include, for example, silicon oxide and/or one or more high-k dielectric materials. In the present specification, a high-k dielectric material may be defined as a material having a higher dielectric constant than a dielectric constant of a silicon oxide. The isolation insulating pattern 120 may include an insulating material (e.g., silicon oxide, silicon nitride, and/or silicon oxynitride).

A lower gate capping pattern GCP1 may be disposed between each of the gate electrodes GE and the lower insulating layer 110, and an upper gate capping pattern GCP2 may be disposed on each of the gate electrodes GE. Each of the gate electrodes GE may be interposed between the lower gate capping pattern GCP1 and the upper gate capping pattern GCP2 (in the third direction D3). The lower gate capping pattern GCP1, each of the gate electrodes GE, and the upper gate capping pattern GCP2 may be sequentially stacked in the third direction D3, at a first side of each of the semiconductor patterns SP.

A lower back-gate capping pattern BCP1 may be disposed between each of the back-gate electrodes BGE and the lower insulating layer 110, and an upper back-gate capping pattern BCP2 may be disposed on each of the back-gate electrodes BGE. Each of the back-gate electrodes BGE may be interposed between the lower back-gate capping pattern BCP1 and the upper back-gate capping pattern BCP2 (in the third direction D3). The lower back-gate capping pattern BCP1, each of the back-gate electrodes BGE, and the upper back-gate capping pattern BCP2 may be sequentially stacked in the third direction D3, at a second side of each of the semiconductor patterns SP, which may be opposite to the first side of each of the semiconductor patterns SP in the first direction D1. The first and second sides may be alternated. For instance, the first side of the first semiconductor pattern SP may be opposite (e.g. may face) the first side of the second semiconductor pattern SP. Similarly, the second side of the first semiconductor pattern SP1 may be opposite (e.g. may face away from) the second side of the second semiconductor pattern SP2.

The arrangement of a row of semiconductor patterns SP will now be described with reference to FIGS. 5 and 6. Each of the semiconductor patterns SP in the row may be disposed between a corresponding one of the gate electrodes GE and a corresponding one of the back-gate electrodes BGE (in the first direction D1). Each of the semiconductor patterns SP may extend (in the third direction D3) between the (corresponding) lower gate capping pattern GCP1 and the (corresponding) lower back-gate capping pattern BCP1 and may be (electrically) connected to a corresponding one of the lower conductive contacts DC. Each of the semiconductor patterns SP may extend (in the third direction D3) between the (corresponding) upper gate capping pattern GCP2 and the (corresponding) upper back-gate capping pattern BCP2.

The gate insulating pattern GI may be interposed between each of the semiconductor patterns SP and the corresponding gate electrode GE and may extend (in the third direction D3) between each of the semiconductor patterns SP and the (corresponding) lower gate capping pattern GCP1 and between each of the semiconductor patterns SP and the (corresponding) upper gate capping pattern GCP2. The back-gate insulating pattern BGI may be interposed between each of the semiconductor patterns SP and the corresponding back-gate electrode BGE and may extend (in the third direction D3) between each of the semiconductor patterns SP and the (corresponding) lower back-gate capping pattern BCP1 and between each of the semiconductor patterns SP and the (corresponding) upper back-gate capping pattern BCP2. The gate insulating pattern GI and the back-gate insulating pattern BGI may be spaced apart from each other in the first direction D1, with each of the semiconductor patterns SP interposed therebetween. A thickness BGI_T of the back-gate insulating pattern BGI in the first direction D1 may be greater (larger) than a thickness GI_T of the gate insulating pattern GI in the first direction D1.

A lower surface (e.g., a bottom surface) GE_L of each of the gate electrodes GE may be adjacent to the lower gate capping pattern GCP1, and a lower surface (e.g., a bottom surface) BGE_L of each of the back-gate electrodes BGE may be adjacent to the lower back-gate capping pattern BCP1. In an embodiment, the lower surface GE_L of each of the gate electrodes GE and the lower surface BGE_L of each of the back-gate electrodes BGE may be located at (substantially) the same height from the substrate 100. In the present specification, the height may be a distance measured from the upper surface 100U of the substrate 100 in the third direction D3. For example, when element A is higher than element B, element A is farther than element B from the upper surface 100U of the substrate 100 in the third direction D3. An upper surface (e.g., top surface) GE_U of each of the gate electrodes GE may be adjacent to the upper gate capping pattern GCP2, and an upper surface (e.g., a top surface) BGE_U of each of the back-gate electrodes BGE may be adjacent to the upper back-gate capping pattern BCP2. In an embodiment, the upper surface GE_U of each of the gate electrodes GE may be located at a height that is higher than the upper surface BGE_U of each of the back-gate electrodes BGE. Accordingly, a thickness (in the third direction D3) of each of the gate electrodes GE may be greater than a thickness (in the third direction D3) of each of the back gate electrodes BGE.

Each of the semiconductor patterns SP may include a lower source/drain region SD1 provided in a lower portion of each of the semiconductor patterns SP, an upper source/drain region SD2 provided in an upper portion of each of the semiconductor patterns SP, and a channel region CH between the lower and upper source/drain regions SD1 and SD2 (in the third direction D3). For clarity, the arrangement of a single semiconductor pattern SP will be described below; however, it will be appreciated that this description may apply equally to other semiconductor patterns SP. The lower and upper source/drain regions SD1 and SD2 may be impurity regions that are doped with dopants of the same conductivity type (e.g., n or p type). A dopant concentration in the lower and upper source/drain regions SD1 and SD2 may be greater (higher) than a dopant concentration in the channel region CH. The lower source/drain region SD1 may be disposed between the lower gate capping pattern GCP1 and the lower back-gate capping pattern BCP1 (in the first direction D1) and may be (electrically) connected to the corresponding lower conductive contact DC. For example, the lower source/drain region SD1 may overlap the lower gate capping pattern GCP1 and the lower back-gate capping pattern BCP1 in the first direction D1. The upper source/drain region SD2 may be disposed between the upper gate capping pattern GCP2 and the upper back-gate capping pattern BCP2 (in the first direction D1). For example, the upper source/drain region SD2 may overlap the upper gate capping pattern GCP2 and the upper back-gate capping pattern BCP2 in the first direction D1. The channel region CH may be disposed between the corresponding gate electrode GE and the corresponding back-gate electrode BGE (in the first direction D1). For example, the channel region CH may overlap the corresponding gate electrode GE and the corresponding back-gate electrode BGE in the first direction D1. As used herein, "an element A overlapping an element B in a direction X" (or similar language) means that there is at least one line that extends in the direction X and intersects both the elements A and B.

Each of the semiconductor patterns SP, the corresponding gate electrode GE, the gate insulating pattern GI, the corresponding back-gate electrode BGE, and the back-gate insulating pattern BGI may constitute a vertical channel transistor (e.g., the selection element TR in FIG. 1).

In an embodiment, a portion of the channel region CH may extend (in the third direction D3) between the upper gate capping pattern GCP2 and the upper back-gate capping pattern BCP2 (in the first direction D1). The portion of the channel region CH may not overlap the corresponding gate electrode GE in in the first direction D1 and may be referred to as an underlap region UL. The underlap region UL may be interposed between a remaining portion of the channel region CH and the upper source/drain region SD2 (in the third direction D3). In some embodiments, the lower source/drain region SD1, the upper source/drain region SD2, and the channel region CH, including the underlap region UL may be integrated in a monolithic or unitary structure (the semiconductor pattern SP) without a structurally or visibly separate interfaces therein. Nevertheless, the underlap region UL may be distinguished from the upper source/drain region SD2 due to its relative dopant concentration. For instance, a dopant concentration in the upper source/drain region SD2 may be greater (higher) than a dopant concentration in the underlap region UL. For instance, the underlap region UL may have a same or similar dopant concentration to the remaining portion of the channel region CH. The underlap region UL may help to reduce the effect of leakage current (e.g. gate induced drain leakage (GIDL)). Having said this, owing to the presence of the underlap region UL, an electric resistance of the vertical channel transistor may be increased when a gate voltage (e.g., a positive voltage) is applied to the corresponding gate electrode GE, and thus, a current flow between the channel region CH and the upper source/drain region SD2 may be reduced. Accordingly, the operational characteristics of the vertical channel transistor may be deteriorated.

In an embodiment, the upper gate capping pattern GCP2 and the upper back-gate capping pattern BCP2 may include an insulating material, and the upper gate capping pattern GCP2 may include an insulating material having a greater (a higher) dielectric constant than that of the upper back-gate capping pattern BCP2. In other words, the upper gate capping pattern GCP2 may include a first insulating material, the upper back-gate capping pattern BCP2 may include a second insulating material, and a dielectric constant of the first insulating material may be greater (higher) than a dielectric constant of the second insulating material. In some embodiments, the upper gate capping pattern GCP2 may have a greater (a higher) dielectric constant than the upper back-gate capping pattern BCP2. As an example, the upper gate capping pattern GCP2 may include silicon oxide, silicon nitride, and/or one or more metal oxide materials, and the upper back-gate capping pattern BCP2 may include an air gap, silicon oxide, silicon nitride, and/or the one or more metal oxide materials. The one or more metal oxide materials may include, for example, aluminum oxide, tantalum oxide, titanium oxide, strontium titanium oxide, zirconium oxide, hafnium oxide, hafnium silicon oxide, lanthanum oxide, yttrium oxide, and/or amorphous lanthanum aluminum oxide.

In addition, the lower gate capping pattern GCP1 and the lower back-gate capping pattern BCP1 may include an insulating material, and the lower gate capping pattern GCP1 may include an insulating material having a greater (a higher) dielectric constant than the lower back-gate capping pattern BCP1. For example, the lower gate capping pattern GCP1 may include a third insulating material, the lower back-gate capping pattern BCP1 may include a fourth insulating material, and a dielectric constant of the third insulating material may be greater (higher) than a dielectric constant of the fourth insulating material. In some embodiments, the lower gate capping pattern GCP1 may have a greater (a higher) dielectric constant than the lower back-gate capping pattern BCP1. In an embodiment, the lower gate capping pattern GCP1 may include, for example, silicon oxide, silicon nitride, and/or the one or more metal oxide materials, and the lower back-gate capping pattern BCP1 may include, for example, an air gap, silicon oxide, silicon nitride, and/or the one or more metal oxide materials.

In an embodiment, the upper gate capping pattern GCP2 may include an insulating material having a greater (a higher) dielectric constant than those of the upper back-gate capping pattern BCP2 and the lower back-gate capping pattern BCP1. The lower gate capping pattern GCP1 may include an insulating material having a greater (a higher) dielectric constant than those of the upper back-gate capping pattern BCP2 and the lower back-gate capping pattern BCP1. In some embodiments, the upper gate capping pattern GCP2 may have a greater (a higher) dielectric constant than the upper back-gate capping BCP2 and/or the lower back-gate capping pattern BCP1. The upper gate capping pattern GCP2 and the lower gate capping pattem GCP1 may include the same material. The upper back-gate capping pattern BCP2 and the lower back-gate capping pattern BCP1 may include the same material.

Since the upper gate capping pattern GCP2 includes an insulating material having a greater (a higher) dielectric constant than that of the upper back-gate capping pattern BCP2, a fringe field E1 by the corresponding gate electrode GE may be increased when a gate voltage (e.g., a positive voltage) is applied to the corresponding gate electrode GE. Accordingly, an additional current flow may be induced in the underlap region UL, and this can lead to an increase of the current flow between the channel region CH and the upper source/drain region SD2. In addition, since the lower gate capping pattern GCP1 includes an insulating material having a greater (a higher) dielectric constant than that of the lower back-gate capping pattern BCP1, the fringe field E1 by the corresponding gate electrode GE may be increased when a gate voltage (e.g., a positive voltage) is applied to the corresponding gate electrode GE. Thus, a current flow between the channel region CH and the lower source/drain region SD1 may be increased. As a result, an electric resistance of the vertical channel transistor may be lowered, and the operational characteristics of the vertical channel transistor may be improved.

The upper back-gate capping pattern BCP2 may include an insulating material having a less (a lower) dielectric constant than that of the upper gate capping pattern GCP2, and the lower back-gate capping pattern BCP1 may include an insulating material having a less (a lower) dielectric constant than that of the lower gate capping pattern GCP1. Accordingly, when a back-gate voltage (e.g., a negative voltage) is applied to the corresponding back-gate electrode BGE, a fringe field E2 by the back-gate electrode BGE may be reduced or minimized. As a result, a leakage current (e.g., a gate-induced drain current (GIDL)) of the vertical channel transistor may be reduced or minimized.

According to an embodiment of the inventive concept, since the upper gate capping pattern GCP2 includes an insulating material having a greater (a higher) dielectric constant than that of the upper back-gate capping pattern BCP2, the fringe field E1 caused by the corresponding gate electrode GE may be increased, and the fringe field E2 caused by the back-gate electrode BGE may be decreased. Accordingly, the current flow between the channel region CH and the upper source/drain region SD2 may be increased, and a leakage current (e.g., a gate-induced drain current (GIDL)) of the vertical channel transistor may be reduced or minimized.

In addition, since the lower gate capping pattern GCP1 includes an insulating material having a greater (a higher) dielectric constant than that of the lower back-gate capping pattern BCP1, a fringe field E1 by the corresponding gate electrode GE may be increased, and the fringe field E2 by the back-gate electrode BGE may be decreased. Accordingly, the current flow between the channel region CH and the lower source/drain region SD1 may be increased, and a leakage current (e.g., a gate-induced drain current (GIDL)) of the vertical channel transistor may be reduced or minimized.

As a result, the vertical channel transistor in the semiconductor device may be provided to have improved operational and electrical characteristics.

Referring to FIGS. 4 to 6, an upper insulating layer 130 may be disposed on the upper gate capping pattern GCP2, the upper back-gate capping pattern BCP2, and the isolation insulating pattern 120 to cover (or overlap in the third direction D3) the upper (e.g., uppermost) surfaces of the upper gate capping pattern GCP2, the upper back-gate capping pattern BCP2, and the isolation insulating pattern 120. The upper insulating layer 130 may be extended to regions on the upper (e.g., the uppermost) surfaces of the gate insulating pattern GI and the back-gate insulating pattern BGI.

Upper conductive contacts BC may be disposed in the upper insulating layer 130. The upper conductive contacts BC may be disposed on the semiconductor patterns SP, respectively, and may be spaced apart from each other in the first and second directions D1 and D2. The upper conductive contacts BC may be (electrically) connected to the semiconductor patterns SP, respectively. Each of the upper conductive contacts BC may be provided to extend in (e.g., penetrate) the upper insulating layer 130 and may be (electrically) connected to the upper source/drain region SD2 of each of the semiconductor patterns SP. The upper conductive contacts BC may include a conductive material, such as one or more doped semiconductor materials (e.g., doped silicon and/or doped germanium), one or more metallic materials (e.g., Ti, Mo, W, Cu, Al, Ta, Ru, Ir, and/or Co), one or more metal silicide materials (e.g., silicide materials containing Ti, Mo, W, Cu, Al, Ta, Ru, Ir, and/or Co), and/or one or more conductive metal nitride materials (e.g., one or more nitride materials containing Ti, Mo, W, Cu, Al, Ta, Ru, Ir, and/or Co).

The upper insulating layer 130 may (at least partially) fill a space between the upper conductive contacts BC. In an embodiment, the upper insulating layer 130 may include an insulating material having a greater (a higher) dielectric constant than that of the upper back-gate capping pattern BCP2. That is, the upper insulating layer 130 may include a fifth insulating material, and a dielectric constant of the fifth insulating material may be greater (higher) than a dielectric constant of the second insulating material of the upper back-gate capping pattern BCP2. In some embodiments, the upper insulating layer 130 may have a greater (a higher) dielectric constant than the upper back-gate capping pattern BCP2. In addition, the upper insulating layer 130 may include an insulating material having a greater (a higher) dielectric constant than the lower back-gate capping pattern BCP1. In other words, a dielectric constant of the fifth insulating material of the upper insulating layer 130 may be greater (higher) than a dielectric constant of the fourth insulating material of the lower back-gate capping pattern BCP1. In some embodiments, the upper insulating layer 130 may have a greater (a higher) dielectric constant than the lower back-gate capping pattern BCP1. In an embodiment, the upper insulating layer 130 may include, for example, silicon oxide, silicon nitride, and/or the one or more metal oxide materials. In an embodiment, the upper insulating layer 130 may include the same material as the upper gate capping pattern GCP2 and/or the lower gate capping pattern GCP1. In an embodiment, the upper insulating layer 130, the upper gate capping pattern GCP2, and the lower gate capping pattern GCP1 may include the same material.

According to an embodiment of the inventive concept, since the upper insulating layer 130 includes an insulating material having a greater (a higher) dielectric constant than the upper back-gate capping pattern BCP2 and/or the lower back-gate capping pattern BCP1, a leakage current (e.g., a gate-induced drain current (GIDL)) of the vertical channel transistor may be reduced or minimized.

Data storage patterns DSP (e.g., the data storage element DS in FIG. 1) may be disposed on the upper conductive contacts BC, respectively, and may be spaced apart from each other in the first and second directions D1 and D2. Each of the data storage patterns DSP may be electrically connected to the upper source/drain region SD2 of each of the semiconductor patterns SP through each of the upper conductive contacts BC. The lower source/drain region SD1 of each of the semiconductor patterns SP may be electrically connected to a corresponding one of the bit lines BL through each of the lower conductive contacts DC.

The semiconductor device may be a random access memory (RAM) device. In an embodiment, each of the data storage patterns DSP may be a capacitor including a bottom electrode, a top electrode, and a dielectric layer therebetween. In this case, the semiconductor device may be a dynamic random access memory (DRAM) device. In another example, each of the data storage patterns DSP may be a magnetic tunnel junction pattern, and in this case, the semiconductor device may be a magnetic random access memory (MRAM) device. In other embodiments, each of the data storage patterns DSP may include a phase-change material or a variable resistance material, and in this case, the semiconductor device may be a phase-change random access memory (PRAM) device or a resistive random access memory (ReRAM) device. However, the inventive concept is not limited to these examples, and the data storage pattern DSP may include various structures and/or materials that can be used to store data therein.

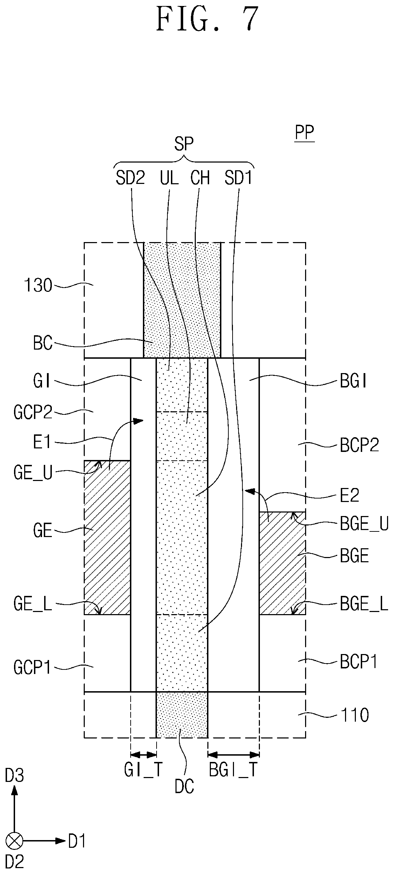

FIG. 7 is an enlarged sectional view illustrating a portion (e.g., 'PP' of FIG. 5) of a semiconductor device according to an embodiment of the inventive concept. For the sake of brevity, features, which are different from the semiconductor device described with reference to FIGS. 1 to 6, will be mainly described below.

Referring to FIGS. 5 and 7, the upper gate capping pattern GCP2 and the upper back-gate capping pattern BCP2 in an embodiment may include an insulating material, and the upper gate capping pattern GCP2 may include an insulating material having a greater (a higher) dielectric constant than that of the upper back-gate capping pattern BCP2. In other words, the upper gate capping pattern GCP2 may include a first insulating material, the upper back-gate capping pattern BCP2 may include a second insulating material, and a dielectric constant of the first insulating material may be greater (higher) than a dielectric constant of the second insulating material. In some embodiments, the upper gate capping pattern GCP2 may have a greater (a higher) dielectric constant than the upper back-gate capping pattern BCP2. In an embodiment, the upper gate capping pattern GCP2 may include, for example, silicon oxide, silicon nitride, and/or the one or more metal oxide materials, and the upper back-gate capping pattern BCP2 may include, for example, an air gap, silicon oxide, silicon nitride, and/or the one or more metal oxide materials.

The lower gate capping pattern GCP1 and the lower back-gate capping pattern BCP1 may include an insulating material (e.g., silicon oxide, silicon nitride, and/or silicon oxynitride). The lower gate capping pattern GCP1 and the lower back-gate capping pattern BCP1 may include the same insulating material.

According to the present embodiment, since the upper gate capping pattern GCP2 includes an insulating material having a greater (a higher) dielectric constant than that of the upper back-gate capping pattern BCP2, the fringe field E1 caused by the corresponding gate electrode GE may be increased when a gate voltage (e.g., a positive voltage) is applied to the corresponding gate electrode GE. Accordingly, an additional current flow may be induced in the underlap region UL, and this may lead to an increase of the current flow between the channel region CH and the upper source/drain region SD2. As a result, an electric resistance of the vertical channel transistor may be lowered, and the operational characteristics of the vertical channel transistor may be improved.

In addition, since the upper back-gate capping pattern BCP2 includes an insulating material having a less (a lower) dielectric constant than that of the upper gate capping pattern GCP2, the fringe field E2 caused by the back-gate electrode BGE may be reduced or minimized when a back-gate voltage (e.g., a negative voltage) is applied to the corresponding back-gate electrode BGE. As a result, a leakage current (e.g., a gate-induced drain current (GIDL)) of the vertical channel transistor may be reduced or minimized.

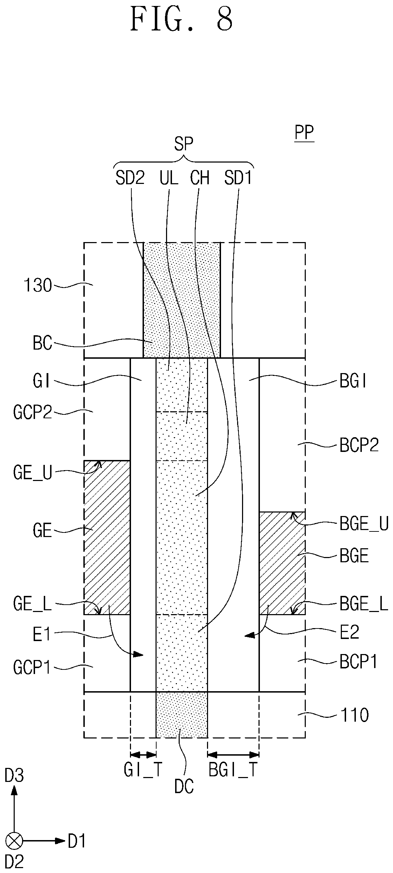

FIG. 8 is an enlarged sectional view illustrating a portion (e.g., 'PP' of FIG. 5) of a semiconductor device according to an embodiment of the inventive concept. For the sake of brevity, features, which are different from the semiconductor device described with reference to FIGS. 1 to 6, will be mainly described below.

Referring to FIGS. 5 and 8, the upper gate capping pattern GCP2 and the upper back-gate capping pattern BCP2 may include, for example, one or more insulating materials (e.g., silicon oxide, silicon nitride, and/or silicon oxynitride). The upper gate capping pattern GCP2 and the upper back-gate capping pattern BCP2 may include the same insulating material.

The lower gate capping pattern GCP1 and the lower back-gate capping pattern BCP1 may include an insulating material, and the lower gate capping pattern GCP1 may include an insulating material having a greater (a higher) dielectric constant than that of the lower back-gate capping pattern BCP1. For example, the lower gate capping pattern GCP1 may include a third insulating material, the lower back-gate capping pattern BCP1 may include a fourth insulating material, and a dielectric constant of the third insulating material may be greater (higher) than that of a dielectric constant of the fourth insulating material. In some embodiments, the lower gate capping pattern GCP1 may have a greater (a higher) dielectric constant than the lower back-gate capping pattern BCP1. In an embodiment, the lower gate capping pattern GCP1 may include, for example, silicon oxide, silicon nitride, and/or the one or more metal oxide materials, and the lower back-gate capping pattern BCP1 may include, for example, an air gap, silicon oxide, silicon nitride, and/or the one or more metal oxide materials.

According to the present embodiment, since the lower gate capping pattern GCP1 includes an insulating material having a greater (a higher) dielectric constant than that of the lower back-gate capping pattern BCP1, the fringe field E1 caused by the corresponding gate electrode GE may be increased when a gate voltage (e.g., a positive voltage) is applied to the corresponding gate electrode GE. Thus, a current flow between the channel region CH and the lower source/drain region SD1 may be increased. As a result, an electric resistance of the vertical channel transistor may be lowered, and the operational characteristics of the vertical channel transistor may be improved.

In addition, since the lower back-gate capping pattern BCP1 includes an insulating material having a less (a lower) dielectric constant than that of the lower gate capping pattern GCP1, the fringe field E2 caused by the back-gate electrode BGE may be reduced or minimized when a back-gate voltage (e.g., a negative voltage) is applied to the corresponding back-gate electrode BGE. As a result, a leakage current (e.g., a gate-induced drain current (GIDL)) of the vertical channel transistor may be reduced or minimized.

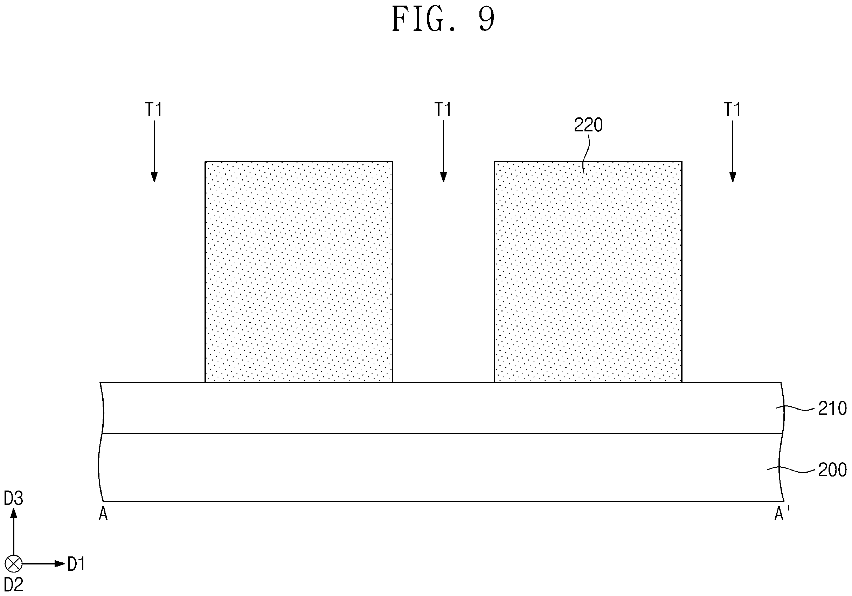

FIGS. 9 to 14 are sectional views illustrating a method of fabricating a semiconductor device according to an embodiment of the inventive concept and corresponding to the line A-A' of FIG. 4. For the sake of brevity, features, which are different from the semiconductor device described with reference to FIGS. 1 to 8, will be mainly described below, and an element described above may be identified by the same reference number without repeating an overlapping description thereof.

Referring to FIGS. 4 and 9, a sacrificial insulating layer 210 may be formed on a sacrificial substrate 200. The sacrificial substrate 200 may be formed of or include a semiconductor material, and the sacrificial insulating layer 210 may be formed of or include an insulating material. A semiconductor layer 220 may be formed on the sacrificial insulating layer 210. The semiconductor layer 220 may be formed of or include, for example, one or more semiconductor materials (e.g., silicon, single-crystalline silicon, germanium, and/or silicon-germanium). In an embodiment, the semiconductor layer 220 may include, for example, one or more oxide semiconductor materials (e.g., InGaZnO, InGaSiO, InSnZnO, InZnO, ZnO, ZnSnO, ZnON, ZrZnSnO, SnO, HfInZnO, GaZnSnO, AlZnSnO, YbGaZnO, and/or InGaO). In an embodiment, the semiconductor layer 220 may include, for example, a two-dimensional semiconductor material (e.g., graphene, carbon nanotube, and/or combinations thereof).

First trenches T1 may be formed in the semiconductor layer 220. Each of the first trenches T1 may be extended in the third direction D3 to penetrate the semiconductor layer 220. The first trenches T1 may be spaced apart from each other in the first direction D1 and may be extended in the second direction D2. The first trenches T1 may be formed by patterning the semiconductor layer 220.

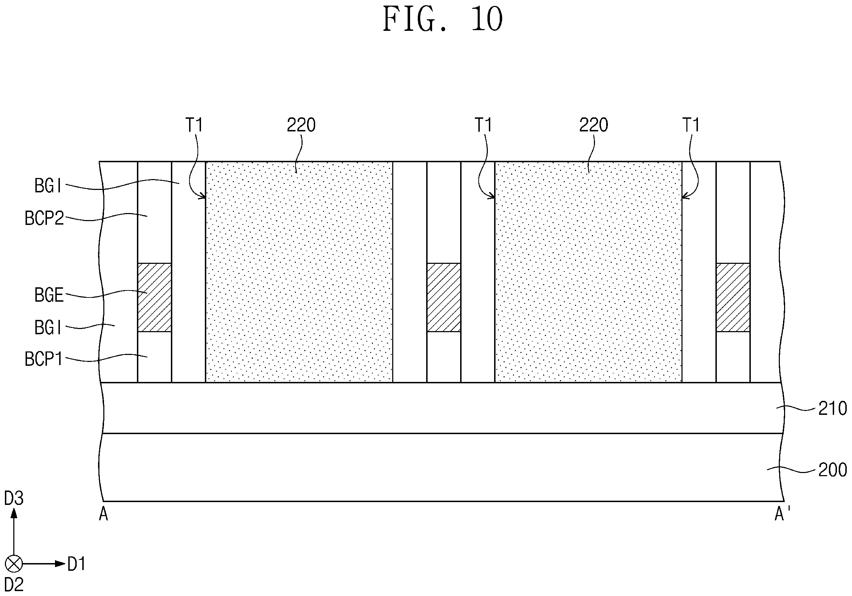

Referring to FIGS. 4 and 10, a back-gate insulating pattern BGI may be formed to fill a portion of each of the first trenches T1. The back-gate insulating pattern BGI may be formed on an inner side surface of each of the first trenches T1, and a pair of back-gate insulating patterns BGI, which are adjacent to each other in each of the first trenches T1, may be spaced apart from each other in the first direction D1. In an embodiment, the formation of the back-gate insulating pattern BGI may include forming a back-gate insulating layer to conformally cover an inner surface of each of the first trenches T1 and removing a portion of the back-gate insulating layer on a lower surface (e.g., a bottom surface) of each of the first trenches T1. In an embodiment, the removal of the portion of the back-gate insulating layer may be performed by an anisotropic etching process.

A lower back-gate capping pattern BCP1 may be formed to (at least partially) fill a lower portion of each of the first trenches T1. In an embodiment, the formation of the lower back-gate capping pattern BCP1 may include forming a lower back-gate capping layer to (at least partially) fill the lower portion of each of the first trenches T1 and recessing the lower back-gate capping layer to leave the lower back-gate capping layer in each of the first trenches T1 to a desired thickness. The lower back-gate capping pattern BCP1 may include, for example, silicon oxide, silicon nitride, and/or one or more metal oxide materials, and here, the one or more metal oxide materials may include, for example, aluminum oxide, tantalum oxide, titanium oxide, strontium titanium oxide, zirconium oxide, hafnium oxide, hafnium silicon oxide, lanthanum oxide, yttrium oxide, and/or amorphous lanthanum aluminum oxide.

A back-gate electrode BGE may be formed to (at least partially) fill a portion of each of the first trenches T1. In an embodiment, the formation of the back-gate electrode BGE may include forming a back-gate electrode layer to (at least partially) fill a portion of each of the first trenches T1 and recessing the back-gate electrode layer to leave the gate electrode layer in each of the first trenches T1 to a desired thickness (on the lower back-gate capping pattern BCP1).

An upper back-gate capping pattern BCP2 may be formed to (at least partially) fill a (remaining) portion of each of the first trenches T1. In an embodiment, the formation of the upper back-gate capping pattern BCP2 may include forming an upper back-gate capping layer on the semiconductor layer 220 to (at least partially) fill a (remaining) portion of each of the first trenches T1 and planarizing the upper back-gate capping layer to expose an upper surface (e.g., a top surface) of the semiconductor layer 220. The upper back-gate capping pattern BCP2 may include, for example, silicon oxide, silicon nitride, and/or the one or more metal oxide materials.

The lower back-gate capping pattern BCP1, the back-gate electrode BGE, and the upper back-gate capping pattern BCP2 may be interposed between the pair of (adjacent) back-gate insulating patterns BGI (in the first direction D1).

Isolation trenches may be formed in the semiconductor layer 220. The isolation trenches may be formed between the first trenches T1. The isolation trenches may be extended in the first direction D1, between a pair of the first trenches T1, which are (most) adjacent to each other in the first direction D1, and may be spaced apart from each other in the second direction D2. Each of the isolation trenches may be extended in the third direction D3 to penetrate the semiconductor layer 220. Isolation patterns may be formed to fill the isolation trenches. The isolation patterns may be formed of or include an insulating material (e.g., silicon oxide, silicon nitride, and/or silicon oxynitride).

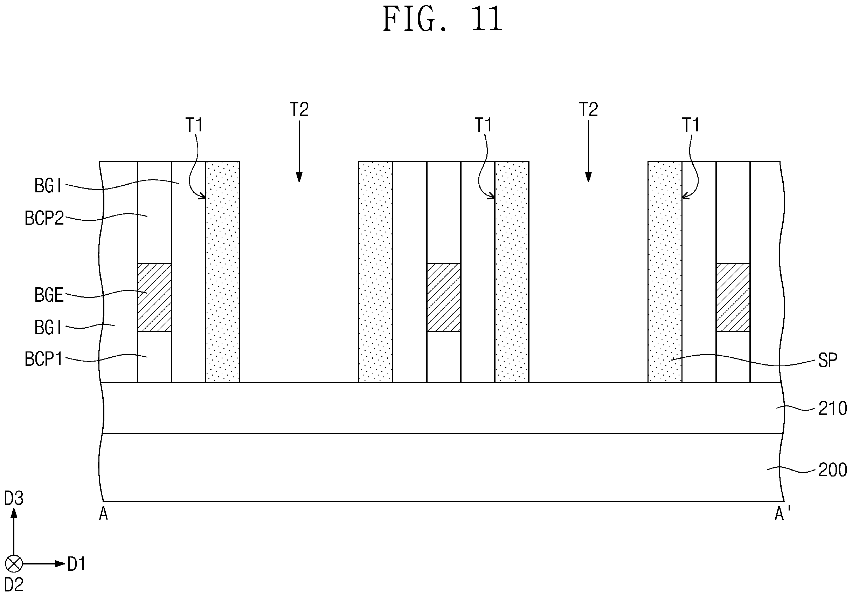

Referring to FIGS. 4 and 11, second trenches T2 may be formed in the semiconductor layer 220. Each of the second trenches T2 may be formed between a pair of the first trenches T1, which are (most) adjacent to each other in the first direction D1, and may be extended in the third direction D3 to penetrate the semiconductor layer 220 and the isolation patterns. The second trenches T2 may be spaced apart from each other in the first direction D1 and may be extended in the second direction D2. The first trenches T1 and the second trenches T2 may be alternatingly arranged in the first direction D1. The second trenches T2 may be formed by patterning the semiconductor layer 220 and the isolation patterns. Since the semiconductor layer 220 is patterned by the second trenches T2, a plurality of semiconductor patterns SP may be formed. The semiconductor patterns SP may be spaced apart from each other in the first and second directions D1 and D2. Each of the semiconductor patterns SP may be a vertical semiconductor pattern, which is elongated in the third direction D3.

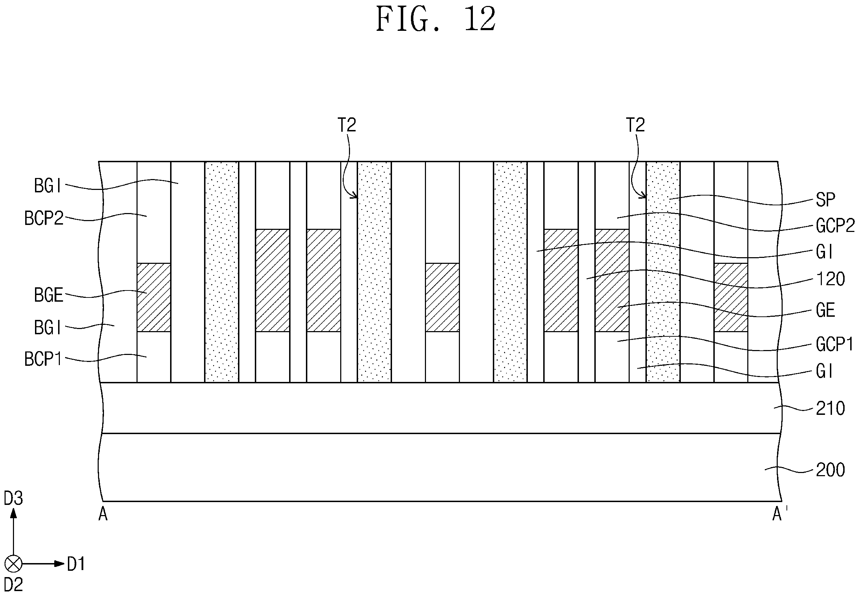

Referring to FIGS. 4 and 12, a gate insulating pattern GI may be formed to (at least partially) fill a portion of each of the second trenches T2. The gate insulating pattern GI may be formed on an inner side surface of each of the second trenches T2, and an adjacent pair of the gate insulating patterns GI in each of the second trenches T2 may be spaced apart from each other in the first direction D1. In an embodiment, the formation of the gate insulating pattern GI may include forming a gate insulating layer to conformally cover an inner surface of each of the second trenches T2 and removing a portion of the gate insulating layer on a lower surface (e.g., a bottom surface) of each of the second trenches T2. In an embodiment, the removal of the portion of the gate insulating layer may be performed by an anisotropic etching process.

A lower gate capping pattern GCP1 may be formed to (at least partially) fill a lower portion of each of the second trenches T2. In an embodiment, the formation of the lower gate capping pattern GCP1 may include forming a lower gate capping layer to (at least partially) fill a lower portion of each of the second trenches T2 and recessing the lower gate capping layer to leave the lower gate capping layer in each of the second trenches T2 to a desired thickness (on the sacrificial insulating layer 210). The lower gate capping pattern GCP1 may include, for example, silicon oxide, silicon nitride, and/or one or more metal oxide materials.

A gate electrode GE may be formed to (at least partially) fill a portion of each of the second trenches T2. In an embodiment, the formation of the gate electrode GE may include forming a gate electrode layer to (at least partially) fill a portion of each of the second trenches T2 and recessing the gate electrode layer to leave the gate electrode layer in each of the second trenches T2 to a desired thickness (on the lower gate capping pattern GCP1).

An upper gate capping pattern GCP2 may be formed to (at least partially) fill a (remaining) portion of each of the second trenches T2. In an embodiment, the formation of the upper gate capping pattern GCP2 may include forming an upper gate capping layer on the semiconductor patterns SP to (at least partially) fill a (remaining) portion of each of the second trenches T2 and planarizing the upper gate capping layer to expose upper surfaces (e.g., top surfaces) of the semiconductor patterns SP. The upper gate capping pattern GCP2 may include, for example, silicon oxide, silicon nitride, and/or the one or more metal oxide materials.

The lower gate capping pattern GCP1, the gate electrode GE, and the upper gate capping pattern GCP2 may be interposed between the pair of (adjacent) gate insulating patterns GI.

An isolation insulating pattern 120 may be formed in each of the second trenches T2. The isolation insulating pattern 120 may be formed to extend in (e.g., penetrate) the lower gate capping pattern GCP1, the gate electrode GE, and the upper gate capping pattern GCP2 and may be extended in the second direction D2. The lower gate capping pattern GCP1 may be divided into a pair of lower gate capping patterns GCP1, which are spaced apart from each other in the first direction D1, by the isolation insulating pattern 120. The gate electrode GE may be divided into a pair of gate electrodes GE, which are spaced apart from each other in the first direction D1, by the isolation insulating pattern 120. The upper gate capping pattern GCP2 may be divided into a pair of upper gate capping patterns GCP2, which are spaced apart from each other in the first direction D1, by the isolation insulating pattern 120.

In an embodiment, an upper portion of each of the semiconductor patterns SP may be doped with dopants. Accordingly, the upper source/drain region SD2 described with reference to FIGS. 6 to 8 may be formed in the upper portion of each of the semiconductor patterns SP.

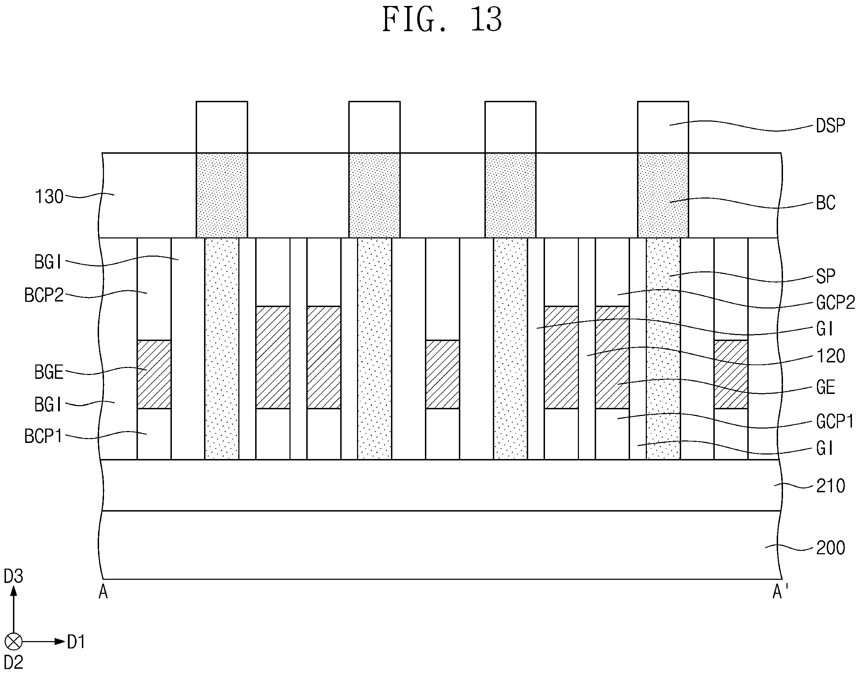

Referring to FIGS. 4 and 13, an upper insulating layer 130 may be formed on (e.g., to cover or overlap in the third direction D3) the upper gate capping pattern GCP2, the gate insulating pattern GI, the isolation insulating pattern 120, the upper back-gate capping pattern BCP2, the back-gate insulating pattern BGI, and the semiconductor patterns SP.

Upper conductive contacts BC may be formed in the upper insulating layer 130. The upper conductive contacts BC may be spaced apart from each other in the first and second directions D1 and D2. Each of the upper conductive contacts BC may be provided to extend in (e.g., penetrate) the upper insulating layer 130 and may be (electrically) connected to each of the semiconductor patterns SP. In an embodiment, the formation of the upper conductive contacts BC may include forming upper contact holes to penetrate the upper insulating layer 130 and expose the semiconductor patterns SP, forming an upper contact layer on the upper insulating layer 130 to fill the upper contact holes, and planarizing the upper contact layer to expose an upper surface (e.g., a top surface) of the upper insulating layer 130. As a result of the planarization process, the upper conductive contacts BC may be locally formed in the upper contact holes, respectively.

Data storage patterns DSP may be formed on the upper conductive contacts BC, respectively. In an embodiment, the formation of the data storage patterns DSP may include forming a data storing layer on the upper insulating layer 130 and patterning the data storing layer.

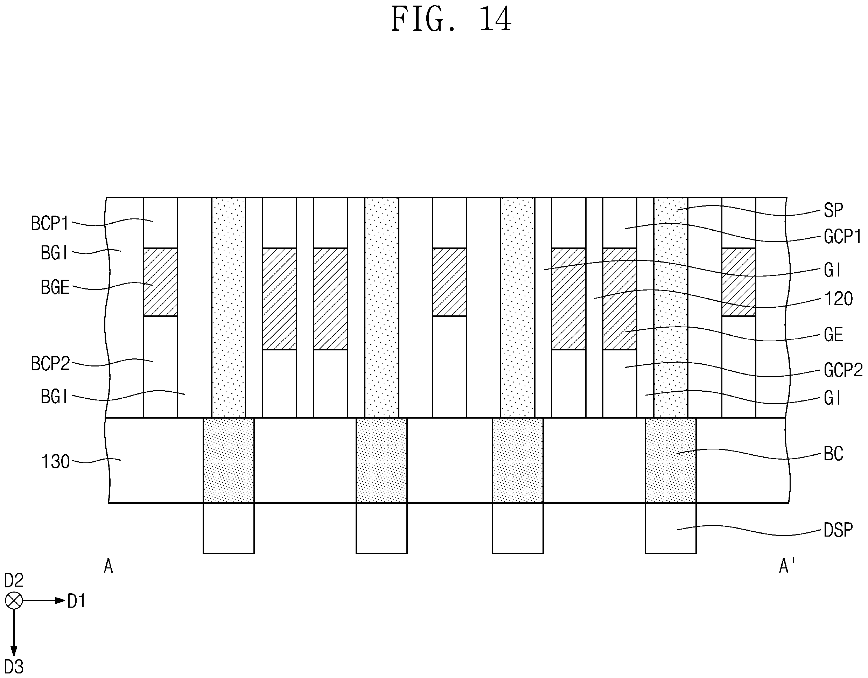

Referring to FIGS. 4 and 14, the structure of FIG. 13 may be inverted, and then, the sacrificial substrate 200 and the sacrificial insulating layer 210 may be removed. Accordingly, lower surfaces (e.g., bottom surfaces) of the lower gate capping pattern GCP1, the gate insulating pattern GI, the isolation insulating pattern 120, the lower back-gate capping pattern BCP1, the back-gate insulating pattern BGI, and the semiconductor patterns SP (which are facing upwardly in FIG. 14) may be exposed to the outside.

In an embodiment, a lower portion of each of the semiconductor patterns SP may be doped with dopants. Accordingly, the lower source/drain region SD1 described with reference to FIGS. 6 to 8 may be formed in the lower portion of each of the semiconductor patterns SP.

Referring back to FIGS. 4 and 5, a lower insulating layer 110 may be formed on (to cover or overlap in the third direction D3) the lower gate capping pattern GCP1, the gate insulating pattern GI, the isolation insulating pattern 120, the lower back-gate capping pattern BCP1, the back-gate insulating pattern BGI, and the semiconductor patterns SP.

Lower conductive contacts DC may be formed in the lower insulating layer 110. The lower conductive contacts DC may be spaced apart from each other in the first and second directions D1 and D2. The lower conductive contacts DC may be provided to extend in (e.g., penetrate) the lower insulating layer 110 and may be (electrically) connected to the semiconductor patterns SP, respectively. In an embodiment, the formation of the lower conductive contacts DC may include forming lower contact holes to extend in (e.g., penetrate) the lower insulating layer 110 and expose the semiconductor patterns SP, forming a lower contact layer on the lower insulating layer 110 to (at least partially) fill the lower contact holes, and planarizing the lower contact layer to expose an upper surface (e.g., a top surface) of the lower insulating layer 110. The lower conductive contacts DC may be locally formed in the lower contact holes, respectively, by the planarization process.

Bit lines BL may be formed on the lower insulating layer 110. The bit lines BL may be extended in the first direction D1 and may be spaced apart from each other in the second direction D2. Insulating patterns may be interposed between the bit lines BL and may be extended in the first direction D1 between the bit lines BL. Each of the bit lines BL may be (electrically) connected in common to some of the lower conductive contacts DC, which are spaced apart from each other in the first direction D1. Some of the lower conductive contacts DC, which are spaced apart from each other in the second direction D2, may be (electrically) connected to the (corresponding) bit lines BL, respectively.

A substrate 100 may be formed on the bit lines BL. In an embodiment, the substrate 100 may include the first substrate SUB1 and the peripheral circuit structure PS of FIG. 2 and may further include an insulating layer on (covering) the peripheral circuit structure PS. In an embodiment, the substrate 100 may include the second substrate SUB2 of FIG. 3 and may further include an insulating layer on the second substrate SUB2.

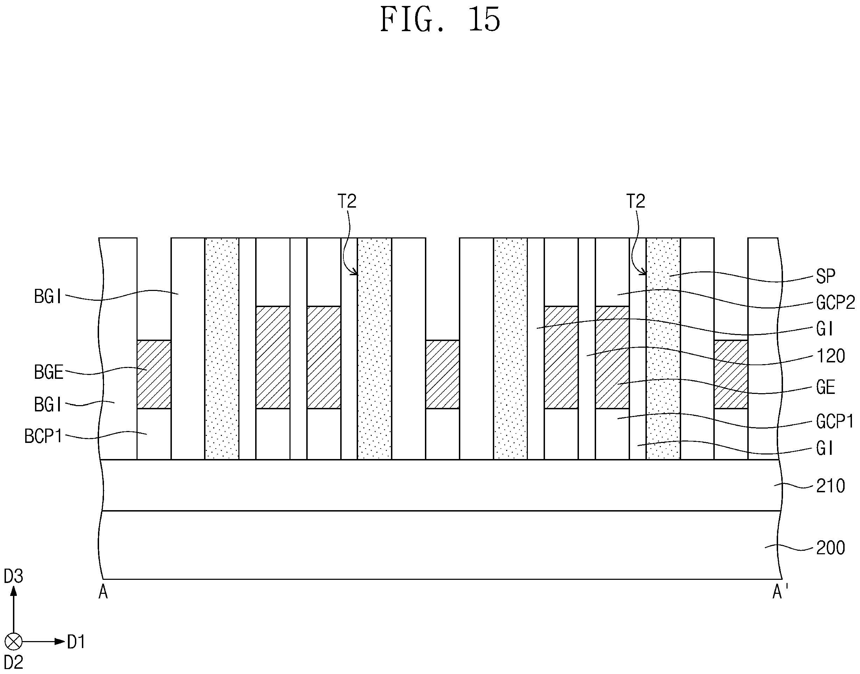

FIGS. 15 to 18 are sectional views illustrating a method of fabricating a semiconductor device according to an embodiment of the inventive concept and corresponding to the line A-A' of FIG. 4. For the sake of brevity, features, which are different from the fabrication method described with reference to FIGS. 9 to 14, will be mainly described below.

In an embodiment, the lower back-gate capping pattern BCP1 and the upper back-gate capping pattern BCP2 described with reference to FIGS. 4 and 10 may be formed of or include a sacrificial material (e.g., silicon oxide).

Referring to FIGS. 4 and 15, the upper back-gate capping pattern BCP2 may be removed. The removal of the upper back-gate capping pattern BCP2 may be performed using a dry or wet etching process.

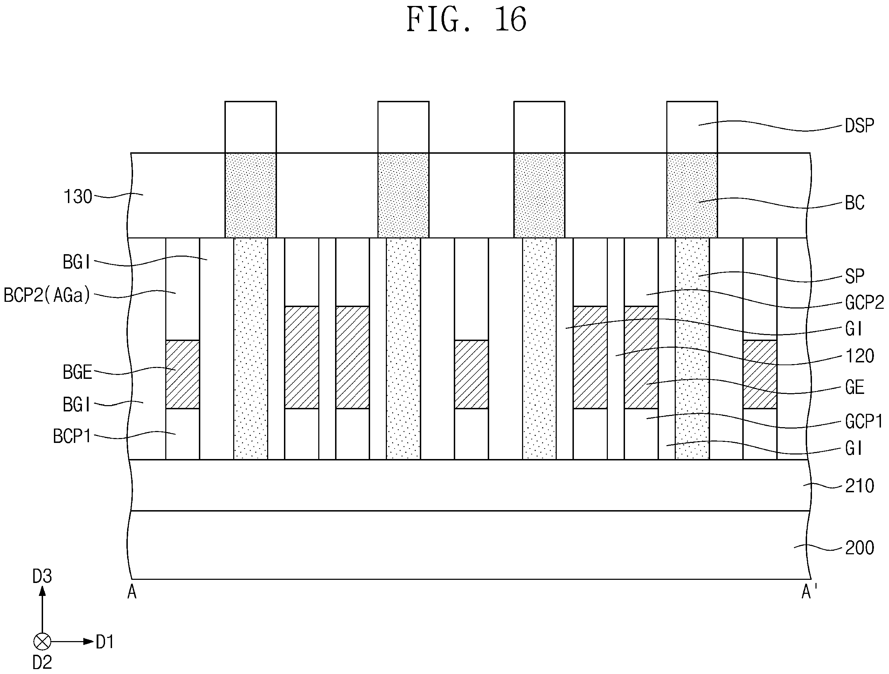

Referring to FIGS. 4 and 16, the upper insulating layer 130 may be formed to cover the upper gate capping pattern GCP2, the gate insulating pattern GI, the isolation insulating pattern 120, the back-gate insulating pattern BGI, and the semiconductor patterns SP. The upper insulating layer 130 may be formed to cover an empty region, which is formed by removing the upper back-gate capping pattern BCP2. Accordingly, an upper air gap AGa may be formed between the pair of (adjacent) back-gate insulating patterns BGI and between the back-gate electrode BGE and the upper insulating layer 130. The upper air gap AGa may be referred to as the upper back-gate capping pattern BCP2.

In another embodiment, the upper back-gate capping pattern BCP2 may be removed after the formation of the upper insulating layer 130. In an embodiment, the upper insulating layer 130 may be formed to cover the upper gate capping pattern GCP2, the gate insulating pattern GI, the isolation insulating pattern 120, the upper back-gate capping pattern BCP2, the back-gate insulating pattern BGI, and the semiconductor patterns SP. After the formation of the upper insulating layer 130, the upper back-gate capping pattern BCP2 may be removed. Thus, the upper air gap AGa may be formed between the pair of (adjacent) back-gate insulating patterns BGI and between the back-gate electrode BGE and the upper insulating layer 130. The upper air gap AGa may be referred to as the upper back-gate capping pattern BCP2.

The upper conductive contacts BC may be formed in the upper insulating layer 130. The upper conductive contacts BC may be spaced apart from each other in the first and second directions D1 and D2. Each of the upper conductive contacts BC may be provided to extend in (e.g., penetrate) the upper insulating layer 130 and may be (electrically) connected to each of the semiconductor patterns SP. The data storage patterns DSP may be formed on the upper conductive contacts BC, respectively.

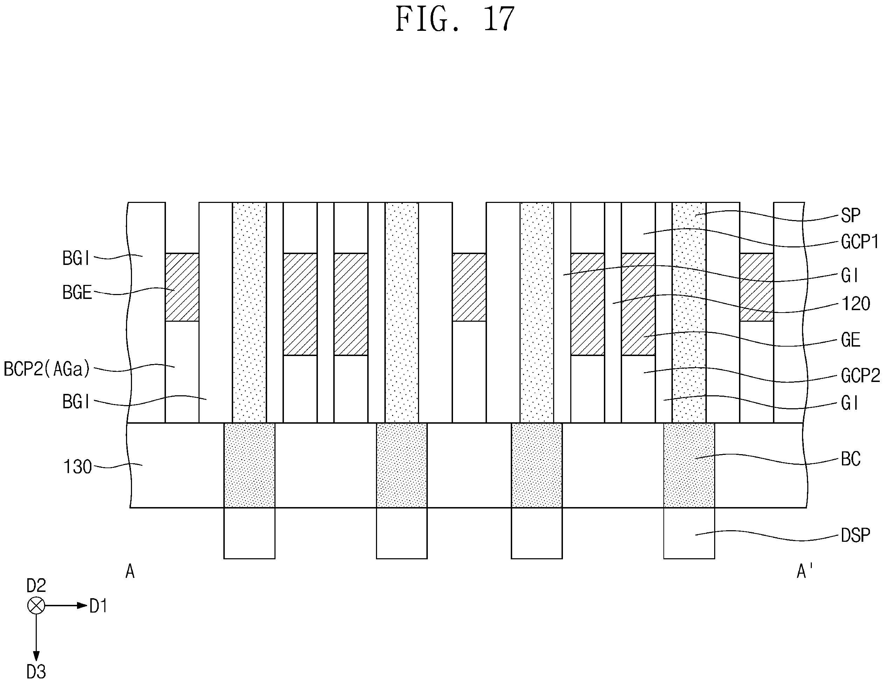

Referring to FIGS. 4 and 17, the structure of FIG. 16 may be inverted, and then, the sacrificial substrate 200 and the sacrificial insulating layer 210 may be removed. Accordingly, lower surfaces (e.g., bottom surfaces) of the lower gate capping pattern GCP1, the gate insulating pattern GI, the isolation insulating pattern 120, the lower back-gate capping pattern BCP1, the back-gate insulating pattern BGI, and the semiconductor patterns SP (which are facing upwardly in FIG. 17) may be exposed to the outside.

In an embodiment, a lower portion of each of the semiconductor patterns SP may be doped with dopants. Thus, the lower source/drain region SD1 described with reference to FIGS. 6 to 8 may be formed in the lower portion of each of the semiconductor patterns SP.

The lower back-gate capping pattern BCP1 may be removed. The removal of the lower back-gate capping pattern BCP1 may be performed using, for example, a dry or wet etching process.

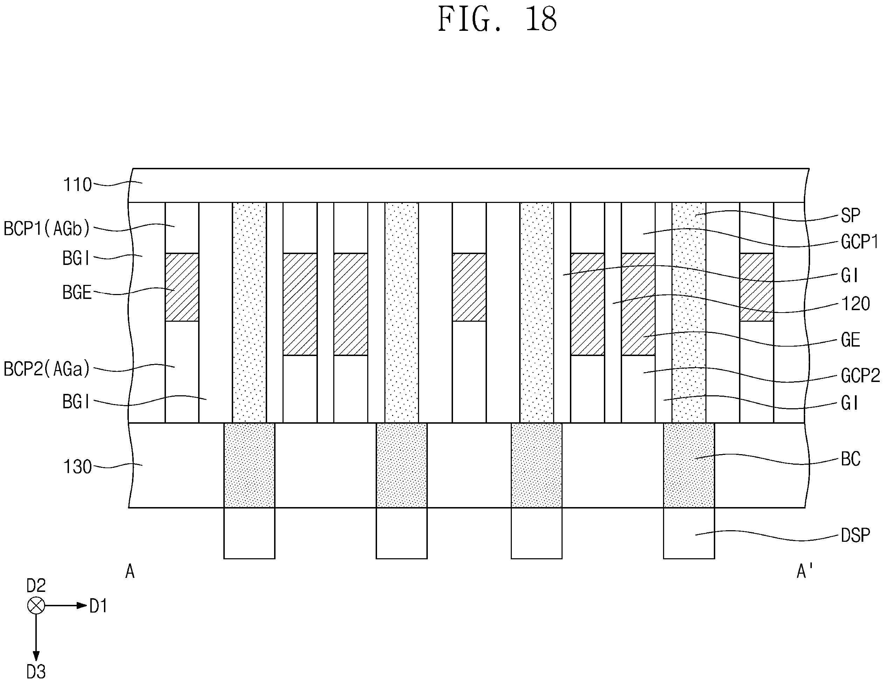

Referring to FIGS. 4 and 18, the lower insulating layer 110 may be formed on (e.g., to cover or overlap in the third direction D3) the lower gate capping pattern GCP1, the gate insulating pattern GI, the isolation insulating pattern 120, the back-gate insulating pattern BGI, and the semiconductor patterns SP. The lower insulating layer 110 may be formed to cover an empty region, which is formed by removing the lower back-gate capping pattern BCP1. Thus, a lower air gap AGb may be formed between the pair of (adjacent) back-gate insulating patterns BGI and between the back-gate electrode BGE and the lower insulating layer 110. The lower air gap AGb may be referred to as the lower back-gate capping pattern BCP1.

In another embodiment, the lower back-gate capping pattern BCP1 may be removed after the formation of the lower insulating layer 110. In an embodiment, the lower insulating layer 110 may be formed on (to cover or overlap in the third direction D3) the lower gate capping pattern GCP1, the gate insulating pattern GI, the isolation insulating pattern 120, the lower back-gate capping pattern BCP1, the back-gate insulating pattern BGI, and the semiconductor patterns SP. After the formation of the lower insulating layer 110, the lower back-gate capping pattern BCP1 may be removed. Thus, the lower air gap AGb may be formed between the pair of (adjacent) back-gate insulating patterns BGI and between the back-gate electrode BGE and the lower insulating layer 110. The lower air gap AGb may be referred to as the lower back-gate capping pattern BCP1.

Referring back to FIGS. 4 and 5, the lower conductive contacts DC may be formed in the lower insulating layer 110. The lower conductive contacts DC may be spaced apart from each other in the first and second directions D1 and D2. The lower conductive contacts DC may be provided to extend in (e.g., penetrate) the lower insulating layer 110 and may be (electrically) connected to the semiconductor patterns SP, respectively.

The bit lines BL may be formed on the lower insulating layer 110. The bit lines BL may be extended in the first direction D1 and may be spaced apart from each other in the second direction D2. The insulating patterns may be interposed between the bit lines BL and may be extended in the first direction D1 between the bit lines BL. The substrate 100 may be formed on the bit lines BL.

Whilst the embodiments of FIGS. 16-18 describe the formation of upper and lower air gaps AGa and AGb, it will be appreciated that in alternative embodiments only one of the upper back-gate capping pattern BCP2 and lower back-gate capping pattern BCP1 may be formed via air gaps. That is, one or both of the upper back-gate capping pattern BCP2 and lower back-gate capping pattern BCP1 may be formed as air gaps.

According to an embodiment of the inventive concept, a vertical channel transistor may be provided to include a semiconductor pattern, which is extended in a vertical direction, a lower gate capping pattern, a gate electrode, and an upper gate capping pattern, which are sequentially stacked in the vertical direction at a side of the semiconductor pattern, and a lower back-gate capping pattern, a back-gate electrode, and an upper back-gate capping pattern, which are sequentially stacked in the vertical direction at an opposite side of the semiconductor pattern. The upper gate capping pattern may include an insulating material having a higher dielectric constant than the upper back-gate capping pattern, and the lower gate capping pattern may include an insulating material having a higher dielectric constant than the lower back-gate capping pattern. In this case, a strength of a fringe field caused by the gate electrode may be increased, and a strength of a fringe field caused by the back-gate electrode may be reduced. Thus, it may be possible to increase a current flowing through the semiconductor pattern of the vertical channel transistor and moreover to reduce a leakage current (e.g., a gate-induced drain current (GIDL)) of the vertical channel transistor.

In addition, an upper insulating layer may be disposed on the vertical channel transistor and may include an insulating material having a higher dielectric constant than the upper and/or lower back-gate capping patterns. In this case, it may be possible to further reduce the leakage current (e.g., the gate-induced drain current (GIDL)) of the vertical channel transistor.

In sum, a semiconductor device including the vertical channel transistor may have improved operational and electrical characteristics, and it may be possible to provide a method of fabricating the same.

When comparing dielectric constants between materials and/or structures, the same measurement parameters (e.g. temperature and frequency) may be utilized. For instance, the relative dielectric constants discussed herein may be measured at room temperature (e.g. a temperature in the region of 20-25°C, such as 20°C or 22°C) and at a frequency that is less than or equal to 1kHz. Nevertheless, the application is not limited to these specific measurement parameters, and alternative measurement parameters may be utilized, provided that the dielectric constants are measured using the same (e.g. standard) measurement parameters.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Embodiments are set out in the following Clauses:
Clause 1. A semiconductor device, comprising:
   a gate electrode and a back-gate electrode on a substrate, wherein the gate electrode and the back-gate electrode are spaced apart from each other in a first direction that is parallel to an upper surface of the substrate and extend in a second direction that is parallel to the upper surface of the substrate and intersects the first direction;
   a semiconductor pattern between the gate electrode and the back-gate electrode in the first direction, wherein the semiconductor pattern extends in a third direction that is perpendicular to the upper surface of the substrate;
   an upper gate capping pattern on the gate electrode; and
   an upper back-gate capping pattern on the back-gate electrode,
   wherein the semiconductor pattern extends between the upper gate capping pattern and the upper back-gate capping pattern, and
   wherein the upper gate capping pattern comprises a first insulating material having a first dielectric constant that is greater than a second dielectric constant of a second insulating material in the upper back-gate capping pattern.
Clause 2. The semiconductor device of Clause 1, further comprising:
   an upper insulating layer on the upper gate capping pattern and the upper back-gate capping pattern; and
   an upper conductive contact extending in the upper insulating layer and electrically connected to the semiconductor pattern,
   wherein the upper insulating layer comprises a third insulating material having a third dielectric constant that is greater than the second dielectric constant of the second insulating material in the upper back-gate capping pattern.
Clause 3. The semiconductor device of Clause 1 or Clause 2, further comprising:
   a lower gate capping pattern between the substrate and the gate electrode; and
   a lower back-gate capping pattern between the substrate and the back-gate electrode,
   wherein the lower gate capping pattern comprises a fourth insulating material having a fourth dielectric constant that is greater than a fifth dielectric constant of a fifth insulating material in the lower back-gate capping pattern.
Clause 4. The semiconductor device of Clause 3, wherein the first dielectric constant is greater than the fifth dielectric constant.
Clause 5. The semiconductor device of Clause 4, wherein the fourth dielectric constant is greater than the second dielectric constant.
Clause 6. The semiconductor device of Clause 5, further comprising:
   an upper insulating layer on the upper gate capping pattern and the upper back-gate capping pattern; and
   an upper conductive contact extending in the upper insulating layer and electrically connected to the semiconductor pattern,
   wherein the upper insulating layer comprises a third insulating material having a third dielectric constant that is greater than the second dielectric constant of the second insulating material in the upper back-gate capping pattern and the fifth dielectric constant of the fifth insulating material in the lower back-gate capping pattern.
Clause 7. The semiconductor device of any of Clauses 3-6, further comprising:
   a gate insulating pattern between the gate electrode and the semiconductor pattern; and
   a back-gate insulating pattern between the back-gate electrode and the semiconductor pattern,
   wherein the gate insulating pattern extends in the third direction between the upper gate capping pattern and the semiconductor pattern and between the lower gate capping pattern and the semiconductor pattern, and
   the back-gate insulating pattern extends in the third direction between the upper back-gate capping pattern and the semiconductor pattern and between the lower back-gate capping pattern and the semiconductor pattern.
Clause 8. The semiconductor device of Clause 7, wherein the gate insulating pattern and the back-gate insulating pattern are spaced apart from each other in the first direction, with the semiconductor pattern interposed therebetween and extend in the second direction, and
   a first thickness of the back-gate insulating pattern in the first direction is greater than a second thickness of the gate insulating pattern in the first direction.
Clause 9. The semiconductor device of Clause 7 or Clause 8, further comprising:
   a lower conductive contact between the substrate and the semiconductor pattern; and
   a bit line between the substrate and the lower conductive contact,
   wherein the semiconductor pattern is electrically connected to the bit line through the lower conductive contact.
Clause 10. The semiconductor device of Clause 9, further comprising:
   an upper insulating layer on the upper gate capping pattern and the upper back-gate capping pattern;
   an upper conductive contact extending in the upper insulating layer and electrically connected to the semiconductor pattern; and
   a data storage pattern on the upper conductive contact,
   wherein the semiconductor pattern is electrically connected to the data storage pattern through the upper conductive contact.
Clause 11. The semiconductor device of Clause 10, wherein the upper insulating layer comprises a third insulating material having a third dielectric constant that is greater than the second dielectric constant of the second insulating material in the upper back-gate capping pattern and the fifth dielectric constant of the fifth insulating material in the lower back-gate capping pattern.
Clause 12. A semiconductor device, comprising:
   a gate electrode and a back-gate electrode on a substrate, wherein the gate electrode and the back-gate electrode are spaced apart from each other in a first direction that is parallel to an upper surface of the substrate;
   a semiconductor pattern between the gate electrode and the back-gate electrode in the first direction, wherein the semiconductor pattern extends in a vertical direction perpendicular to the upper surface of the substrate;
   an upper gate capping pattern on the gate electrode;
   an upper back-gate capping pattern on the back-gate electrode;
   an upper insulating layer on the upper gate capping pattern and the upper back-gate capping pattern; and
   an upper conductive contact extending in the upper insulating layer and electrically connected to the semiconductor pattern,
   wherein the semiconductor pattern comprises:
      a channel region between the gate electrode and the back-gate electrode; and
      an upper source/drain region between the upper gate capping pattern and the upper back-gate capping pattern,
   the upper source/drain region is electrically connected to the upper conductive contact, and
   the upper gate capping pattern comprises a first insulating material having a first dielectric constant that is greater than a second dielectric constant of a second dielectric material in the upper back-gate capping pattern.
Clause 13. The semiconductor device of Clause 12, wherein the upper insulating layer comprises a third insulating material having a third dielectric constant that is greater than the second dielectric constant of the second dielectric material in the upper back-gate capping pattern.
Clause 14. The semiconductor device of Clause 12 or Clause 13, further comprising a data storage pattern on the upper conductive contact, wherein the data storage pattern is electrically connected to the upper conductive contact.
Clause 15. The semiconductor device of any of Clauses 12-14, further comprising:
   a lower gate capping pattern between the substrate and the gate electrode; and
   a lower back-gate capping pattern between the substrate and the back-gate electrode,
   wherein the semiconductor pattern further comprises a lower source/drain region between the lower gate capping pattern and the lower back-gate capping pattern in the first direction.
Clause 16. The semiconductor device of Clause 15, wherein the lower gate capping pattern comprises a fourth insulating material having a fourth dielectric constant that is greater than a fifth dielectric constant of a fifth insulating material in the lower back-gate capping pattern.
Clause 17. The semiconductor device of Clause 15 or Clause 16, further comprising a lower conductive contact between the substrate and the semiconductor pattern,
   wherein the lower source/drain region is electrically connected to the lower conductive contact.
Clause 18. The semiconductor device of Clause 17, further comprising a bit line between the substrate and the lower conductive contact, wherein the bit line is electrically connected to the lower conductive contact.
Clause 19. The semiconductor device of any of Clauses 16-18, wherein the first dielectric constant is greater than the fifth dielectric constant.
Clause 20. The semiconductor device of Clause 19, wherein the fourth dielectric constant is greater than the second dielectric constant.
Clause 21. A semiconductor device, comprising:
   a gate electrode and a back-gate electrode on a substrate, wherein the gate electrode and the back-gate electrode are spaced apart from each other in a first direction that is parallel to an upper surface of the substrate and extend in a second direction that is parallel to the upper surface of the substrate and intersects the first direction;
   a semiconductor pattern between the gate electrode and the back-gate electrode in the first direction, wherein the semiconductor pattern extends in a third direction that is perpendicular to the upper surface of the substrate;
   an upper gate capping pattern on the gate electrode; and
   an upper back-gate capping pattern on the back-gate electrode,
   wherein the semiconductor pattern extends between the upper gate capping pattern and the upper back-gate capping pattern, and
   wherein the upper gate capping pattern has a first dielectric constant that is greater than a second dielectric constant of the upper back-gate capping pattern.
Clause 22. The semiconductor device of Clause 21, further comprising:
   an upper insulating layer on the upper gate capping pattern and the upper back-gate capping pattern; and
   an upper conductive contact extending in the upper insulating layer and electrically connected to the semiconductor pattern,
   wherein the upper insulating layer has a third dielectric constant that is greater than the second dielectric constant of the upper back-gate capping pattern.
Clause 23. The semiconductor device of Clause 21 or Clause 22, further comprising:
   a lower gate capping pattern between the substrate and the gate electrode; and
   a lower back-gate capping pattern between the substrate and the back-gate electrode,
   wherein the lower gate capping pattern has a fourth dielectric constant that is greater than a fifth dielectric constant of the lower back-gate capping pattern.
Clause 24. The semiconductor device of Clause 23, wherein the first dielectric constant is greater than the fifth dielectric constant.
Clause 25. The semiconductor device of Clause 24, wherein the fourth dielectric constant is greater than the second dielectric constant.
Clause 26. The semiconductor device of Clause 25, further comprising:
   an upper insulating layer on the upper gate capping pattern and the upper back-gate capping pattern; and
   an upper conductive contact extending in the upper insulating layer and electrically connected to the semiconductor pattern,
   wherein the upper insulating layer has a third dielectric constant that is greater than the second dielectric constant of the upper back-gate capping pattern and the fifth dielectric constant of the lower back-gate capping pattern.

While example embodiments of the inventive concept have been particularly shown and described, it will be understood by one of ordinary skill in the art that variations in form and detail may be made therein without departing from the scope of the attached claims.

## Claims

1. A semiconductor device, comprising:
a gate electrode and a back-gate electrode on a substrate, wherein the gate electrode and the back-gate electrode are spaced apart from each other in a first direction that is parallel to an upper surface of the substrate and extend in a second direction that is parallel to the upper surface of the substrate and intersects the first direction;
a semiconductor pattern between the gate electrode and the back-gate electrode in the first direction, wherein the semiconductor pattern extends in a third direction that is perpendicular to the upper surface of the substrate;
an upper gate capping pattern on the gate electrode; and
an upper back-gate capping pattern on the back-gate electrode,
wherein the semiconductor pattern extends between the upper gate capping pattern and the upper back-gate capping pattern, and
wherein the upper gate capping pattern has a first dielectric constant that is greater than a second dielectric constant of the upper back-gate capping pattern.

2. The semiconductor device of claim 1, further comprising:
an upper insulating layer on the upper gate capping pattern and the upper back-gate capping pattern, wherein the upper insulating layer has a third dielectric constant; and
an upper conductive contact extending in the upper insulating layer and electrically connected to the semiconductor pattern.

3. The semiconductor device of claim 2, wherein the third dielectric constant is greater than the second dielectric constant of the upper back-gate capping pattern.

4. The semiconductor device of claim 2 or claim 3, further comprising a data storage pattern on the upper conductive contact, wherein the semiconductor pattern is electrically connected to the data storage pattern through the upper conductive contact.

5. The semiconductor device of any preceding claim, further comprising:
a lower gate capping pattern between the substrate and the gate electrode; and
a lower back-gate capping pattern between the substrate and the back-gate electrode,
wherein the lower gate capping pattern has a fourth dielectric constant that is greater than a fifth dielectric constant of the lower back-gate capping pattern.

6. The semiconductor device of claim 5, wherein the first dielectric constant is greater than the fifth dielectric constant.

7. The semiconductor device of claim 5 or claim 6, wherein the fourth dielectric constant is greater than the second dielectric constant.

8. The semiconductor device of any of claims 5-7 when dependent on any of claims 2-4, wherein:
the third dielectric constant is greater than the fifth dielectric constant of the lower back-gate capping pattern.

9. The semiconductor device of any of claims 5-8, further comprising:
a gate insulating pattern between the gate electrode and the semiconductor pattern; and
a back-gate insulating pattern between the back-gate electrode and the semiconductor pattern,
wherein the gate insulating pattern extends in the third direction between the upper gate capping pattern and the semiconductor pattern and between the lower gate capping pattern and the semiconductor pattern, and
the back-gate insulating pattern extends in the third direction between the upper back-gate capping pattern and the semiconductor pattern and between the lower back-gate capping pattern and the semiconductor pattern.

10. The semiconductor device of claim 9, wherein the gate insulating pattern and the back-gate insulating pattern each extend in the second direction and are spaced apart from each other in the first direction, with the semiconductor pattern interposed therebetween, and
a first thickness of the back-gate insulating pattern in the first direction is greater than a second thickness of the gate insulating pattern in the first direction.

11. The semiconductor device of any preceding claim, further comprising:
a lower conductive contact between the substrate and the semiconductor pattern; and
a bit line between the substrate and the lower conductive contact,
wherein the semiconductor pattern is electrically connected to the bit line through the lower conductive contact.
